# EUROPEAN PATENT APPLICATION

(11) **EP 3 277 055 A1**
(43) Date of publication of application: **31.01.2018**
(21) Application number: 16768933.0
(22) Date of filing: 25.03.2016
(51) Int. Cl.: H05B 33/04, H01L 51/50

(54) **SEALING MATERIAL, METHOD FOR MANUFACTURING SEALING MATERIAL, AND METHOD FOR MANUFACTURING LIGHT-EMITTING DEVICE**

(30) Priority: 26.03.2015 JP 2015064849
(71) Applicant: Zeon Corporation, Tokyo 100-8246 (JP)
(72) Inventor: HARAI, Kenichi, Tokyo 100-8246 (JP)
(74) Representative: Hansen, Norbert
(86) International application number: PCT/JP2016/059593
(87) International publication number: WO 2016/153030

(57) **Abstract**

Provided is a sealing material for sealing in a light-emitting element, the sealing material having a bonding surface that can be in contact with the light-emitting element, an arithmetic mean roughness of the bonding surface being 10 nm or greater and 1000 nm or less. A storage elastic modulus of the sealing material at 90'C is preferably 10 MPa or greater. The sealing material preferably contains a metal compound. A method for manufacturing a light-emitting device of the present invention includes a step
for bonding the bonding surface of the sealing material to the light-emitting element, and a step for bonding a barrier member to a surface of the sealing material opposite to the bonding surface.

## Description

### Field

The present invention relates to a sealing material, a method for producing the sealing material, and a method for producing a light-emitting device using the sealing material.

### Background

In general, an organic electroluminescent element (hereinafter, also appropriately referred to as an "organic EL element") can be formed in a form of a thin film and made flexible. Thus, various types of light-emitting devices have been developed by using the organic EL element.

The organic EL element contains an organic material that is susceptible to damages caused by water and the air. Thus, in the light-emitting device including the organic EL element, the organic EL element is generally sealed to protect the organic material from water and the air (See Patent Literature 1).

### Citation List

### Patent Literature

Patent Literature 1: International Publication No. 2014/91941 (corresponding foreign application: European Patent Application Publication No. 2,930,210)

### Summary

### Technical Problem

The light-emitting device including the sealed organic EL element usually has a sealing structure in which the organic EL element is covered with an appropriate barrier member. The sealing structure described herein may be classified into a hollow sealing structure, in which the organic EL element and the barrier member are disposed with a space therebetween, and a tight-contact sealing structure, in which the space described above is filled with a sealing material. Of these, the tight-contact sealing structure has been mainly used in recent year as the light-emitting device can be easily made flexible.

Examples of the method for the tight-contact sealing may include the one using a curable resin, such as a thermosetting resin and a photocurable resin, as the sealing material. In this method, the curable resin is filled into the space between the organic EL element and the barrier member and cured to perform the sealing. However, the curable resin used as the sealing material sometimes caused damages to the organic EL element due to the shrinkage of the resin when cured.

Further, in another method, a material having high flexibility, such as a filler material and a gel material, is used as the sealing material. In this method, the sealing material is filled into the space between the organic EL element and the barrier member to perform the sealing. However, when the sealing was performed using the sealing material having high flexibility such as those, the barrier member was sometimes brought into contact with the organic EL element upon bending the light-emitting device, and caused damages to the organic EL element.

In this regard, the applicant has proposed a technique in which the sealing is performed by press-bonding a film sealing material in Patent Literature 1.

However, when the sealing was performed by press-bonding the film sealing material as described in Patent Literature 1, air bubbles were sometimes generated between the organic EL element and the sealing material, resulting in insufficient sealing. Further, when the sealing was performed by press-bonding the film sealing material, the organic EL element was sometimes damaged by pressing during the process of bonding the sealing material and the organic EL element, which in turn caused generation of dark spots. The dark spots herein refer to a part where the light-emitting element locally fails to emit light (light-emission defect).

The aforementioned problems related to the sealing may also occur when the light-emitting element other than the organic EL element is sealed. Thus, there has been an extensive demand for a technology which enables sealing of the light-emitting element while suppressing the occurrence of the air bubbles and the dark spots.

The present invention has been made in view of the aforementioned problems, and an object of the present invention is to provide: a sealing material capable of sealing a light-emitting element while suppressing the occurrence of air bubbles and dark spots; a production method thereof; and a method for producing a light-emitting device including the light-emitting element sealed with the aforementioned sealing material.

### Solution to Problem

The present inventor has conducted earnest studies to solve the aforementioned problem and found that the occurrence of air bubbles and dark spots upon sealing can be suppressed by roughening of a bonding surface of the sealing material for sealing a light-emitting element that is capable of being in contact with the light-emitting element so that the surface has a specific arithmetic average roughness. On the basis of this finding, the present invention has been completed.

Specifically, the present invention provides the following.

(1) A sealing material for sealing a light-emitting element, wherein:
   the sealing material has a bonding surface capable of being in contact with the light-emitting element; and
   the bonding surface has an arithmetic average roughness of 10 nm or more and 1,000 nm or less.
(2) The sealing material according to (1), wherein the sealing material has a storage elastic modulus at 90°C of 10 MPa or more.
(3) The sealing material according to (1) or (2), wherein the sealing material has a tensile elastic modulus at 23°C of 1,500 MPa or less.
(4) The sealing material according to any one of (1) to (3), wherein the sealing material is formed of a thermoplastic resin.
(5) The sealing material according to (4), wherein the thermoplastic resin contains a hydrogenated product of an aromatic vinyl compound-conjugated diene block copolymer.
(6) The sealing material according to any one of (1) to (5), wherein the sealing material contains a metal compound.
(7) A method for producing the sealing material according to any one of (1) to (6), comprising the steps of:
   molding a resin for forming the sealing material to obtain a resin film; and
   processing a surface of the resin film to form a bonding surface having an arithmetic average roughness of 10 nm or more and 1,000 nm or less.
(8) A method for producing a light-emitting device, comprising the steps of:
   bonding a bonding surface of the sealing material according to any one of (1) to (6) to a light-emitting element; and
   bonding a barrier member to a surface of the sealing material on a side opposite to the bonding surface.

### Advantageous Effects of Invention

According to the present invention, there can be provided: a sealing material capable of sealing a light-emitting element while suppressing the occurrence of air bubbles and dark spots; a production method therefor; and a method for producing a light-emitting device including the light-emitting element sealed with the aforementioned sealing material.

### Brief Description of Drawings

FIG. 1 is a vertical cross-sectional view schematically illustrating a light-emitting device according to a first embodiment of the present invention.
FIG. 2 is a perspective view schematically illustrating an organic EL element contained in the light-emitting device according to the first embodiment of the present invention.
FIG. 3 is a vertical cross-sectional view schematically illustrating a light-emitting device according to a second embodiment of the present invention.
FIG. 4 is a vertical cross-sectional view schematically illustrating a light-emitting device according to a third embodiment of the present invention.

### Description of Embodiments

Hereinafter, the present invention will be described in detail with reference to embodiments and examples. However, the present invention is not limited to the following embodiments and examples, which may be optionally modified and implemented without departing from the scope of claims of the present invention and the scope of their equivalents.

### [1. Bonding surface of sealing material]

The sealing material of the present invention is a member for sealing a light-emitting element. The sealing material has a bonding surface that is capable of being in contact with the light-emitting element. Sealing of the light-emitting element can be achieved by bonding the bonding surface to the light-emitting element. The sealing material is usually a member having a surface in a shape of, for example, a film, a sheet, a plate, or the like. As at least one of these surfaces, the sealing material has the bonding surface.

The bonding surface of the sealing material has the arithmetic average roughness Ra of usually 10 nm or more, preferably 20 nm or more, and more preferably 50 nm or more, and is usually 1000 nm or less, preferably 900 nm or less, and more preferably 750 nm or less. When the arithmetic average roughness Ra of the bonding surface is equal to or more than the lower limit value of the aforementioned range, it is possible to efficiently purge the air from a space between the sealing material and the light-emitting element during sealing of the light-emitting element by boding the sealing material to the light-emitting element. This can suppress the occurrence of the air bubbles between the light-emitting element and the sealing material. Further, when the arithmetic average roughness Ra of the bonding surface is equal to or less than the upper limit value of the aforementioned range, it is possible to prevent a high pressure from being locally applied to a part of the light-emitting element during sealing of the light-emitting element by bonding the sealing material to the light-emitting element. This can reduce damages to the light-emitting element caused by the local pressure described above, and thus the occurrence of the dark spots can be reduced.

When the light-emitting element is sealed by the sealing material, a surface of the sealing material on the opposite side of the bonding surface is usually bonded to a barrier member. Thus, in the light-emitting device, the surface of the sealing material on the opposite side to the bonding surface is usually in contact with the barrier member. In this case, the surface of the sealing material, which may be in contact with the barrier member, is preferably formed in a rough surface having a specific arithmetic average roughness Ra for suppressing the occurrence of the air bubbles between the sealing material and the barrier member when they are bonded together. The surface of the sealing material, which may be in contact with the barrier member, has the arithmetic average roughness Ra of preferably 10 nm or more, more preferably 20 nm or more, and particularly preferably 50 nm or more, and of preferably 1000 nm or less, more preferably 900 nm or less, and particularly preferably 750 nm or less. When the arithmetic average roughness Ra of the surface of the sealing material, which may be in contact with the barrier member, is equal to or more than the lower limit value of the aforementioned range, the occurrence of the air bubbles between the sealing material and the barrier member can be suppressed. Further, the arithmetic average roughness Ra is equal to or less than the upper limit value of the aforementioned range, the occurrence of dark spots can be suppressed by suppressing damages to the light-emitting element.

The arithmetic average roughness Ra of the bonding surface of the sealing material may be measured by observing the bonding surface of the sealing material with an atomic force microscope.

### [2. Material of sealing material]

The sealing material described above is usually formed of a resin. The resin described above is preferably a thermoplastic resin. The thermoplastic resin becomes plasticized and flexible by heating at a specific sealing temperature, and thus can be easily in tight contact with the light-emitting element to seal it. Such a thermoplastic resin usually contains a thermoplastic polymer and an optional component if necessary.

### [2. 1. Polymer]

As the polymer, an elastomer is preferably used. The elastomer is a polymer having rubber elasticity at the room temperature without a vulcanization treatment. The room temperature described herein usually refers to 25°C. In the following description, a resin containing the elastomer and the optional component if necessary may be appropriately referred to as an "elastomer resin". In general, the elastomer resin does not contain a residual solvent or, even if it does, contains a small amount, and thus the elastomer resin generates little outgas. Therefore the elastomer resin hardly generates the gas under a low pressure environment. Consequently, deterioration of the light-emitting element caused by the gas from the sealing material can be suppressed.

As the elastomer, a block copolymer elastomer and a hydrogenated block copolymer elastomer are preferable. The block copolymer elastomer is an elastomer formed of a block copolymer. Further, the hydrogenated block copolymer elastomer is an elastomer formed of a hydrogenated product of the block copolymer. Properties of the block copolymer and the hydrogenated product thereof may be usually adjusted depending on the types and ratios of the polymer blocks contained in their molecular structures. When the block copolymer and the hydrogenated product thereof are an elastomer, the block copolymer usually contains a polymer block as a rubber component having elasticity (i.e., a soft segment) and a polymer block as a molecule-restraining component for preventing plastic deformation (i.e., a hard segment) in the molecule.

As the block copolymer described above, an aromatic vinyl compound-conjugated diene block copolymer is preferable. The aromatic vinyl compound-conjugated diene block copolymer described herein refers to a block copolymer containing a polymer block [A] having an aromatic vinyl compound unit as a main component and a polymer block [B] having a linear conjugated diene compound unit as a main component. Further, the aromatic vinyl compound unit refers to a structural unit having a structure formed by polymerization of an aromatic vinyl compound. Further, the linear conjugated diene compound unit refers to a structural unit having a structure formed by polymerization of a linear conjugated diene compound. These block copolymers and the hydrogenated products thereof may be modified by, for example, alkoxysilane, carboxylic acid, and carboxylic acid anhydride.

Of these, as the elastomer, a hydrogenated product formed by hydrogenating a specific block copolymer that contains two or more per molecule of the copolymer the polymer blocks [A] having the aromatic vinyl compound unit as a main component, and one or more per molecule of the copolymer the polymer blocks [B] having the linear conjugated diene compound unit as a main component is preferable.

### (2. 1. 1. Specific block copolymer)

The polymer block [A] contained in the specific block copolymer has the aromatic vinyl compound unit. Examples of an aromatic vinyl compound corresponding to the aromatic vinyl compound unit contained in the polymer block [A] may include styrene, α-methylstyrene, 2-methylstyrene, 3-methylstyrene, 4-methylstyrene, 2,4-diisopropylstyrene, 2,4-dimethylstyrene, 4-t-butylstyrene, 5-t-butyl-2-methylstyrene, 4-monochlorostyrene, dichlorostyrene, 4-monofluorostyrene, and 4-phenylstyrene. One type thereof may be solely used, and two or more types thereof may also be used in combination at any ratio. Of these, the aromatic vinyl compound having no polar group is preferable in terms of hygroscopicity. Further, styrene is particularly preferable from the viewpoint of industrial availability and impact resistance.

The content ratio of the aromatic vinyl compound unit in the polymer block [A] is preferably 90% by weight or more, more preferably 95% by weight or more, and particularly preferably 99% by weight or more. By containing a large amount of the aromatic vinyl compound unit in the polymer block [A] as described above, heat resistance of the sealing material can be enhanced.

The polymer block [A] may contain an optional structural unit other than the aromatic vinyl compound unit. Examples of the optional structural unit may include a linear conjugated diene compound unit and a structural unit having a structure that is formed by polymerization of a vinyl compound other than the aromatic vinyl compound.

Examples of the linear conjugated diene compound corresponding to the linear conjugated diene compound unit may include the same examples as those of the linear conjugated diene compound corresponding to the linear conjugated diene compound unit contained in the polymer block [B]. As the linear conjugated diene compound, one type thereof may be solely used, and two or more types thereof may also be used in combination at any ratio.

Examples of the vinyl compound other than the aromatic vinyl compound may include: a linear vinyl compound; a cyclic vinyl compound; a vinyl compound having a nitrile group, an alkoxycarbonyl group, a hydroxycarbonyl group, or a halogen group; an unsaturated cyclic acid anhydride; and an unsaturated imide compound. Of these, preferable in terms of hygroscopicity are those containing no polar group, including: a linear olefin, such as ethylene, propylene, 1-butene, 1-pentene, 1-hexene, 1-heptene, 1-octene, 1-nonene, 1-decene, 1-dodecene, 1-eicosene, 4-methyl-1-pentene, and 4,6-dimethyl-1-heptene; and a cyclic olefin, such as vinylcyclohexane. Of these, the linear olefin is more preferable, and ethylene and propylene are particularly preferable. One type thereof may be solely used, and two or more types thereof may also be used in combination at any ratio.

The content ratio of the optional structural unit in the polymer block [A] is preferably 10% by weight or less, more preferably 5% by weight or less, and particularly preferably 1% by weight or less.

The number of the polymer blocks [A] per molecule of the block copolymer is preferably two or more, and preferably five or less, more preferably four or less, and particularly preferably three or less. When there are a plurality of the polymer blocks [A] in one molecule, they may be the same as or different from each other.

When a plurality of different polymer blocks [A] are present in one molecule of the block copolymer, let Mw(A1) denote the weight-average molecular weight of the polymer block having the maximum weight-average molecular weight among the polymer blocks [A], and Mw(A2) denote the weight-average molecular weight of the polymer block having the minimum weight-average molecular weight among the polymer blocks [A]. In such a case, the ratio between Mw(A1) and Mw(A2) "Mw(A1)/Mw(A2)" is preferably 2.0 or less, more preferably 1.5 or less, and particularly preferably 1.2 or less. By having the ratio in this range, fluctuations in various properties can be suppressed to a low level.

On the other hand, the polymer block [B] contained in the block copolymer has the linear conjugated diene compound unit. Examples of the linear conjugated diene compound corresponding to the linear conjugated diene compound unit contained in the polymer block [B] may include 1,3-butadiene, isoprene, 2,3-dimethyl-1,3-butadiene, and 1,3-pentadiene. One type thereof may be solely used, and two or more types thereof may also be used in combination at any ratio. Of these, the linear conjugated diene compound having no polar group is preferable in terms of hygroscopicity, and 1,3-butadiene and isoprene are particularly preferable.

The content ratio of the linear conjugated diene compound unit in the polymer block [B] is preferably 90% by weight or more, more preferably 95% by weight or more, and particularly preferably 99% by weight or more. By containing a large amount of the linear conjugated diene compound unit in the polymer block [B] as described above, impact resistance of the sealing material at a low temperature can be enhanced.

The polymer block [B] may contain an optional structural unit other than the linear conjugated diene compound unit. Examples of the optional structural unit may include an aromatic vinyl compound unit and a structural unit having a structure that is formed by polymerization of a vinyl compound other than the aromatic vinyl compound. Examples of the aromatic vinyl compound unit and the structural unit having a structure that is formed by polymerization of the vinyl compound other than the aromatic vinyl compound may include those exemplified as those that may be contained in the polymer block [A].

The content ratio of the optional structural unit in the polymer block [B] is preferably 10% by weight or less, more preferably 5% by weight or less, and particularly preferably 1% by weight or less. In particular, by lowering the content ratio of the aromatic vinyl compound unit in the polymer block [B], flexibility of the sealing material at a low temperature can be enhanced, and thus impact resistance of the sealing material at a low temperature can be improved.

The number of the polymer blocks [B] per molecule of the block copolymer is usually one or more, however, it may be two or more. When there are two or more of the polymer blocks [B] in the block copolymer, they may be the same as or different from each other.

Further, when a plurality of different polymer blocks [B] are present in one molecule of the block copolymer, let Mw(B1) denote the weight-average molecular weight of the polymer block having the maximum weight-average molecular among the polymer blocks [B], and Mw(B2) denote the weight-average molecular weight of the polymer block having the minimum weight-average molecular weight among the polymer blocks [B]. In such a case, the ratio between Mw(B1) and Mw(B2) "Mw(B1)/Mw(B2)" is preferably 2.0 or less, more preferably 1.5 or less, and particularly preferably 1.2 or less. By having the ratio in this range, fluctuations in various properties can be suppressed to a low level.

The block form of the block copolymer may be a linear block or a radial block. Of these, the linear block is excellent in mechanical strength and is thus preferable.

When the block copolymer has the linear block form, it is preferable that both ends of the block copolymer are formed by the polymer blocks [A] because the stickiness of the elastomer resin can be suppressed to a desired low value.

The particularly preferable block forms of the block copolymer are: a tri-block copolymer represented by [A]-[B]-[A], in which the polymer blocks [A] are bonded to both ends of the polymer block [B]; and a penta-block copolymer represented by [A]-[B]-[A]-[B]-[A], in which the polymer blocks [B] are bonded to both ends of the polymer block [A] and other polymer blocks [A] are further bonded to the other ends of these polymer blocks [B]. In particular, the tri-block copolymer of [A]-[B]-[A] is particularly preferable because it is easily produced and properties such as viscosity can be kept within a desired range.

In the block copolymer, the ratio between the weight fraction wA occupied by the total polymer blocks [A] in the entire block copolymer and the weight fraction wB occupied by the total polymer blocks [B] in the entire block copolymer (wA/wB) is preferably 20/80 or more, and more preferably 30/70 or more, and is preferably 60/40 or less, and more preferably 55/45 or less. When the ratio wA/wB described above is equal to or more than the lower limit value of the aforementioned range, heat resistance of the sealing material can be enhanced. Further, when the ratio is equal to or less than the upper limit value, flexibility of the sealing material can be enhanced, and thus the sealing capability of the sealing material can be stably maintained in a favorable manner. Further, the glass transition temperature of the block copolymer can be reduced and the sealing temperature can in turn be reduced, and thus heat deterioration of the light-emitting element can be suppressed.

The weight-average molecular weight (Mw) of the block copolymer described above is preferably 30,000 or more, more preferably 40,000 or more, and particularly preferably 50,000 or more, and is preferably 200,000 or less, more preferably 150,000 or less, and particularly preferably 100,000 or less.

Further, the molecular weight distribution (Mw/Mn) of the block copolymer is preferably 3 or less, more preferably 2 or less, and particularly preferably 1.5 or less, and is preferably 1.0 or more. Mn herein represents the number-average molecular weight.

The weight-average molecular weight and molecular weight distribution of the block copolymer described above may be measured as polystyrene-equivalent values by a gel permeation chromatography (GPC) using tetrahydrofuran (THF) as a solvent.

For example, when the block copolymer having three polymer blocks is produced, as an example of a method for producing the block copolymer, the following production methods 1 and 2 may be mentioned. The material referred to herein as a "monomer composition" encompasses not only a mixture of two or more types of substances, but also a material formed of a single substance.

(Production method 1) A method including: a first step of forming the polymer block [A] by polymerizing a monomer composition (a1) containing an aromatic vinyl compound;
a second step of forming the polymer block [B] by polymerizing a monomer composition (b1) containing a linear conjugated diene compound at one end of the polymer block [A] thus produced to form a di-block polymer of [A]-[B]; and
a third step of polymerizing a monomer composition (a2) containing an aromatic vinyl compound at an end of the di-block polymer on the side of the block [B], to obtain a block copolymer. The monomer composition (a1) and the monomer composition (a2) may be the same as or different from each other.

(Production method 2) A method including: a first step of forming the polymer block [A] by polymerizing the monomer composition (a1) containing the aromatic vinyl compound;
a second step of forming the polymer block [B] by polymerizing the monomer composition (b1) containing the linear conjugated diene compound at one end of the polymer block [A] thus produced to form a di-block polymer of [A]-[B]; and
a third step of coupling the di-block polymers with each other through their ends on the side of the polymer block [B] using a coupling agent to obtain a block copolymer.

As the method for obtaining each polymer block by polymerizing the corresponding monomer composition, for example, radical polymerization, anionic polymerization, cationic polymerization, coordinate anionic polymerization, and coordinate cationic polymerization may be used. From the viewpoint of facilitating the polymerization operation and the subsequent hydrogenation reaction, the radical polymerization, the anionic polymerization, the cationic polymerization, or the like is preferably performed through living polymerization. It is particularly preferable to perform the living anionic polymerization.

The polymerization of the aforementioned monomer composition may be performed in the presence of a polymerization initiator in a temperature range of preferably 0°C or higher, more preferably 10°C or higher, and particularly preferably 20°C or higher, and of preferably 100°C or lower, more preferably 80°C or lower, and particularly preferably 70°C or lower.

Examples of the polymerization initiator for use in the living anionic polymerization may include: a mono-organic lithium, such as n-butyl lithium, sec-butyl lithium, t-butyl lithium, and hexyl lithium; and a polyfunctional organic lithium compound, such as dilithiomethane, 1,4-dilithiobutane, and 1,4-dilithio-2-ethylcyclohexane. One type thereof may be solely used, and two or more types thereof may also be used in combination at any ratio.

As the form of the polymerization reaction, for example, solution polymerization and slurry polymerization may be used. Of these, the use of the solution polymerization facilitates removal of reaction heat.

When the solution polymerization is performed, an inert solvent capable of dissolving the polymer obtained in each step may be used as the solvent. Examples of the inert solvent may include: aliphatic hydrocarbons, such as n-pentane, isopentane, n-hexane, n-heptane, and isooctane; alicyclic hydrocarbons, such as cyclopentane, cyclohexane, methylcyclopentane, methylcyclohexane, and decalin; and aromatic hydrocarbons, such as benzene and toluene. One type thereof may be solely used, and two or more types thereof may also be used in combination at any ratio. Of these, the alicyclic hydrocarbons are preferably used as the solvent since they can be directly used as an inert solvent in the hydrogenation reaction and have excellent solubility of the block copolymer. The amount of the solvent to be used is preferably 200 parts by weight to 2,000 parts by weight relative to 100 parts by weight of all monomers used.

When each monomer composition contains two or more types of monomers, a randomizer, for example, may be used for preventing formation of a long chain of one particular component. In particular, when the polymerization reaction is performed through the anionic polymerization, for example, a Lewis base compound or the like is preferably used as the randomizer. Examples of the Lewis base compound may include: an ether compound, such as dimethyl ether, diethyl ether, diisopropyl ether, dibutyl ether, tetrahydrofuran, diphenyl ether, ethylene glycol diethyl ether, and ethylene glycol methyl phenyl ether; a tertiary amine compound, such as tetramethylethylenediamine, trimethylamine, triethylamine, and pyridine; an alkali metal alkoxide compound, such as potassium-t-amyloxide and potassium-t-butyloxide; and a phosphine compound, such as triphenylphosphine. One type thereof may be solely used, and two or more types thereof may also be used in combination at any ratio.

### (2. 1. 2. Hydrogenated product of specific block copolymer)

As the elastomer for forming the sealing material, a hydrogenated product of the specific block copolymer described above is preferably used. Use of the specific hydrogenated block copolymer can further reduce the amount of outgas generated from the sealing material.

The hydrogenated product of the block copolymer is a polymer obtained by hydrogenating an unsaturated bond of the specific block copolymer described above. The unsaturated bond of the block copolymer described herein includes aromatic and non-aromatic carbon-carbon unsaturated bonds of the main and side chains of the block copolymer. The hydrogenation ratio is preferably 90% or more, more preferably 97% or more, and particularly preferably 99% or more of all unsaturated bonds of the block copolymer. Higher hydrogenation ratio results in better heat resistance and light resistance of the sealing material. The hydrogenation ratio of the hydrogenated product may be determined by the measurement using ¹H-NMR.

In particular, the hydrogenation ratio of the non-aromatic unsaturated bonds is preferably 95% or more, and more preferably 99% or more. By having a high hydrogenation ratio of the non-aromatic carbon-carbon unsaturated bonds, light resistance and oxidation resistance of the sealing material can be further improved.

Further, the hydrogenation ratio of the aromatic carbon-carbon unsaturated bonds is preferably 90% or more, more preferably 93% or more, and particularly preferably 95% or more. By having a high hydrogenation ratio of the carbon-carbon unsaturated bonds of the aromatic rings, glass transition temperature of the polymer block obtained by hydrogenating the polymer block [A] is raised, and heat resistance of the sealing material is effectively enhanced. Further, this lowers the photoelastic coefficient of the sealing material and thus can suppress unintended development of retardation during the sealing process.

The weight-average molecular weight (Mw) of the hydrogenated product of the block copolymer is preferably 30,000 or more, more preferably 40,000 or more, and particularly preferably 45,000 or more, and is preferably 200,000 or less, more preferably 150,000 or less, and particularly preferably 100,000 or less. Further, the molecular weight distribution (Mw/Mn) of the hydrogenated product of the block copolymer is preferably 3 or less, more preferably 2 or less, and particularly preferably 1.5 or less, and is preferably 1.0 or more. When the weight-average molecular weight Mw and molecular weight distribution Mw/Mn of the hydrogenated product of the block copolymer fall within the ranges described above, mechanical strength and heat resistance of the sealing material can be enhanced. The weight-average molecular weight and molecular weight distribution of the hydrogenated product of the block copolymer described above may be measured as polystyrene-equivalent values by the gel permeation chromatography using tetrahydrofuran as a solvent.

In the hydrogenated product of the block copolymer, the ratio between the weight fraction wA occupied by the total polymer blocks [A] in the entire block copolymer and the weight fraction wB occupied by the total polymer blocks [B] in the entire block copolymer (wA/wB) usually has the same value as the wA/wB ratio of the block copolymer before hydrogenation.

Further, the hydrogenated product of the block copolymer preferably contains an alkoxysilyl group in its molecular structure. The hydrogenated product of the block copolymer having the alkoxysilyl group may be obtained, for example, by bonding the alkoxysilyl group to the hydrogenated product of the block copolymer without the alkoxysilyl group. In this process, the alkoxysilyl group may be bonded to the hydrogenated product of the block copolymer directly or through a divalent organic group, such as, for example, an alkylene group.

The hydrogenated product of the block copolymer having the alkoxysilyl group has particularly improved adhesion with a material, such as glass, an inorganic substance, and metal. Thus, when the light-emitting element is sealed by the sealing material, adhesiveness of the sealing material to the light-emitting element can be particularly improved. As a result, even after the exposure to a high temperature and high humidity environment for an extended period of time, the sealing material can maintain sufficient adhesiveness.

The introduction amount of the alkoxysilyl group is preferably 0.1 parts by weight or more, more preferably 0.2 parts by weight or more, and particularly preferably 0.3 parts by weight or more, and is preferably 10 parts by weight or less, more preferably 5 parts by weight or less, and particularly preferably 3 parts by weight or less, relative to 100 parts by weight of the hydrogenated product of the block copolymer before introduction of the alkoxysilyl group. When the introduction amount of the alkoxysilyl group falls within the aforementioned range, a crosslinking degree between the alkoxysilyl groups, which are decomposed with water or the like, can be prevented from becoming excessively large, whereby the adhesiveness of the sealing material can be kept at a high level.

The introduction amount of the alkoxysilyl group may be measured by ¹H-NMR spectrometry. Further, when the introduction amount of the alkoxysilyl group is small in the measurement of the introduction amount of the alkoxysilyl group, the introduction amount may be measured by increasing the cumulative number of the measurements.

The molecular weight of the hydrogenated product of the block copolymer having the alkoxysilyl group is usually not largely altered from the molecular weight of the hydrogenated product of the block copolymer before introduction of the alkoxysilyl group, since the amount of the alkoxysilyl group that is introduced is small. However, when the alkoxysilyl group is introduced, a modification reaction of the hydrogenated product of the block copolymer is performed in the presence of a peroxide. As a result, a crosslinking reaction and cleavage reaction of the hydrogenated product proceed and the molecular weight distribution tends to be largely altered. The weight-average molecular weight of the hydrogenated product of the block copolymer having the alkoxysilyl group is preferably 30,000 or more, more preferably 40,000 or more, and particularly preferably 50,000 or more, and is preferably 200,000 or less, more preferably 150,000 or less, and particularly preferably 120,000 or less. Further, the molecular weight distribution (Mw/Mn) of the hydrogenated product of the block copolymer having the alkoxysilyl group is preferably 3.5 or less, more preferably 2.5 or less, and particularly preferably 2.0 or less, and is preferably 1.0 or more. When the weight-average molecular weight Mw and molecular weight distribution Mw/Mn of the hydrogenated product of the block copolymer having the alkoxysilyl group fall within those ranges, the sealing material can maintain its excellent mechanical strength and tensile stretching. The weight-average molecular weight and molecular weight distribution of the hydrogenated product of the block copolymer having the alkoxysilyl group described above may be measured as polystyrene-equivalent values by the gel permeation chromatography using tetrahydrofuran as a solvent.

The method for producing the hydrogenated product of the block copolymer described above usually includes a step of hydrogenating the specific block copolymer described above. The hydrogenation method is preferably a method that is capable of achieving a high hydrogenation ratio and causing a less chain cleavage reaction of the block copolymer. Examples of the preferable hydrogenation method may include a method wherein hydrogenation is performed using a hydrogenation catalyst containing at least one of metal selected from the group consisting of nickel, cobalt, iron, titanium, rhodium, palladium, platinum, ruthenium, and rhenium. As the hydrogenation catalyst, one type thereof may be solely used, and two or more types thereof may also be used in combination at any ratio. As the hydrogenation catalyst, any of a heterogeneous catalyst and a homogeneous catalyst may be used. Further, the hydrogenation reaction is preferably performed in an organic solvent.

As the heterogeneous catalyst, for example, metal or a metal compound may be used as it is, or it may be used in a form supported by an appropriate carrier. Examples of the carrier may include activated carbon, silica, alumina, calcium carbonate, titania, magnesia, zirconia, diatomaceous earth, silicon carbide, and calcium fluoride. The catalyst carrying amount is preferably 0.1% by weight or more, and more preferably 1% by weight or more, and is preferably 60% by weight or less, and more preferably 50% by weight or less, with respect to the total amount of the catalyst and the carrier. Further, the specific surface area of the carried-type catalyst is preferably 100 m²/g to 500 m²/g. Further, the average pore diameter of the carried-type catalyst is preferably 100 Å or more, more preferably 200 Å or more, and preferably 1,000 Å or less, preferably 500 Å or less. The specific surface area may be obtained by measuring the nitrogen adsorption amount and using the BET equation. Further, the average pore diameter may be measured by the mercury penetration method.

Examples of the homogeneous catalyst for use may include: a catalyst formed by combining a compound of nickel, cobalt, titanium, or iron, and an organometallic compound; and an organometallic complex catalyst, such as rhodium, palladium, platinum, ruthenium, rhenium, or the like.

Examples of the compound of nickel, cobalt, titanium, or iron may include an acetylacetonate compound, a carboxylic acid salt, and a cyclopentadienyl compound of each metal.

Further, examples of the organometallic compound may include: an organic aluminum compound, including an alkyl aluminum, such as triethylaluminum and triisobutylaluminum, an aluminum halide, such as diethylaluminum chloride and ethylaluminum dichloride, and an alkyl aluminum hydride, such as diisobutylaluminum hydride; and an organic lithium compound.

Examples of the organometallic complex catalyst may include a transition metal complex, such as dihydride-tetrakis(triphenylphosphine) ruthenium, dihydride-tetrakis(triphenylphosphine) iron, bis(cyclooctadiene) nickel, and bis(cyclopentadienyl) nickel.

The amount of the hydrogenation catalyst to be used is preferably 0.01 parts by weight or more, more preferably 0.05 parts by weight or more, and particularly preferably 0.1 parts by weight or more, and is preferably 100 parts by weight or less, more preferably 50 parts by weight or less, and particularly preferably 30 parts by weight or less, relative to 100 parts by weight of the block copolymer.

The temperature of the hydrogenation reaction is preferably 10°C or higher, more preferably 50°C or higher, and particularly preferably 80°C or higher, and is preferably 250°C or lower, more preferably 200°C or lower, and particularly preferably 180°C or lower. By performing the hydrogenation reaction in such a temperature range, hydrogenation rate can be raised and molecular cleavage of the block copolymer can be reduced.

Further, the pressure of hydrogen during the hydrogenation reaction is preferably 0.1 MPa or higher, more preferably 1 MPa or higher, and particularly preferably 2 MPa or higher, and is preferably 30 MPa or lower, more preferably 20 MPa or lower, and particularly preferably 10 MPa or lower. By performing the hydrogenation reaction under such a hydrogen pressure, hydrogenation rate can be raised, molecular cleavage of the block copolymer can reduced, and operability can be improved.

As a result of the hydrogenation of the block copolymer in the manner described above, the hydrogenated product of the block copolymer may be obtained as a product. The product after the hydrogenation reaction as it is may be used for forming the sealing material. Alternatively, the product after the hydrogenation reaction may be further subjected to an optional treatment if necessary and then used for forming the sealing material. For example, the product after the hydrogenation reaction may be subjected to a treatment of introducing an alkoxysilyl group if necessary.

As the method for introducing the alkoxysilyl group to the hydrogenated product of the block copolymer, for example, a method in which the hydrogenated product of the block copolymer before introduction of the alkoxysilyl group and an ethylenically unsaturated silane compound are reacted in the presence of a peroxide may be used.

The ethylenically unsaturated silane compound for use may be a compound that is capable of bringing about graft polymerization with the hydrogenated product of the block copolymer to introduce the alkoxysilyl group to the hydrogenated product of the block copolymer. Examples of the ethylenically unsaturated silane compound may include vinyltrimethoxysilane, vinyltriethoxysilane, allyltrimethoxysilane, allyltriethoxysilane, dimethoxymethylvinylsilane, diethoxymethylvinylsilane, p-styryltrimethoxysilane, p-styryltriethoxysilane, 3-methacryloxypropyltrimethoxysilane, 3-methacryloxypropylmethyldimethoxysilane, 3-methacryloxypropyltriethoxysilane, 3-methacryloxypropylmethyldiethoxysilane, 3-acryloxypropyltrimethoxysilane, 3-acryloxypropyltriethoxysilane, and 2-norbornene-5-yltrimethoxysilane. Of these, vinyltrimethoxysilane, vinyltriethoxysilane, allyltrimethoxysilane, allyltriethoxysilane, dimethoxymethylvinylsilane, diethoxymethylvinylsilane, and p-styryltrimethoxysilane are preferable. As the ethylenically unsaturated silane compound, one type thereof may be solely used, and two or more types thereof may also be used in combination at any ratio.

The amount of the ethylenically unsaturated silane compound is preferably 0.1 parts by weight or more, more preferably 0.2 parts by weight or more, and particularly preferably 0.3 parts by weight or more, and is preferably 10 parts by weight or less, more preferably 5 parts by weight or less, and particularly preferably 3 parts by weight or less, relative to 100 parts by weight of the hydrogenated product of the block copolymer before introduction of the alkoxysilyl group.

Examples of the peroxide may include an organic peroxide, such as dibenzoyl peroxide, t-butyl peroxyacetate, 2,2-di-(t-butylperoxy)butane, t-butyl peroxybenzoate, t-butyl cumyl peroxide, dicumyl peroxide, di-t-hexylperoxide, 2,5-dimethyl-2,5-di(t-butyl peroxyhexane), di-t-butyl peroxide, 2,5-dimethyl-2,5-di(t-butyl peroxy)hexane-3, t-butyl hydroperoxide, t-butyl peroxyisobutyrate, lauroyl peroxide, dipropionyl peroxide, and p-menthane hydroperoxide. Of these, the peroxide having a one-minute half-life temperature of 170°C to 190°C is preferable. For example, t-butyl cumyl peroxide, dicumyl peroxide, di-t-hexylperoxide, 2,5-dimethyl-2,5-di(t-butyl peroxyhexane), and di-t-butyl peroxide are preferable. As the peroxide, one type thereof may be solely used, and two or more types thereof may also be used in combination at any ratio.

The amount of the peroxide is preferably 0.01 parts by weight or more, more preferably 0.2 parts by weight or more, and particularly preferably 0.3 parts by weight or more, and is preferably 5 parts by weight or less, more preferably 3 parts by weight or less, and particularly preferably 2 parts by weight or less, relative to 100 parts by weight of the hydrogenated product of the block copolymer before introduction of the alkoxysilyl group.

The aforementioned method for reacting the hydrogenated product of the block copolymer and the ethylenically unsaturated silane compound in the presence of peroxide may be performed, for example, by using a heating kneader and a reaction vessel. More specifically, a mixture of the hydrogenated product of the block copolymer, the ethylenically unsaturated silane compound, and the peroxide is heated and melted at a temperature equal to or higher than the melting temperature of the hydrogenated product of the block copolymer and kneaded for a desired period of time by a twin-screw kneading machine to introduce the alkoxysilyl group to the hydrogenated product of the block copolymer. The specific temperature at the time of kneading is preferably 180°C or higher, more preferably 190°C or higher, and particularly preferably 200°C or higher, and is preferably 240°C or lower, more preferably 230°C or lower, and particularly preferably 220°C or lower. Further, the kneading time is preferably 0.1 minutes or longer, more preferably 0.2 minutes or longer, and particularly preferably 0.3 minutes or longer, and is preferably 15 minutes or shorter, more preferably 10 minutes or shorter, and particularly preferably 5 minutes or shorter. When a continuous kneading facility, such as a twin-screw kneading machine and a single-screw extruder, is used, kneading and extrusion may be continuously performed while keeping the retention time within the aforementioned range.

The hydrogenated product of the block copolymer obtained by the aforementioned method is usually obtained as a reaction liquid containing the hydrogenated product of the block copolymer, the hydrogenation catalyst, and the polymerization catalyst. Thus, the hydrogenated product of the block copolymer may be collected from the reaction liquid after the hydrogenation catalyst and the polymerization catalyst are removed from the reaction liquid, for example, by a method such as filtration and centrifugal separation. Examples of the method for collecting the hydrogenated product of the block copolymer from the reaction liquid may include: a steam solidifying method in which the solvent is removed from the solution, in which the hydrogenated product of the block copolymer is dissolved, by steam stripping; a direct solvent removal method in which the solvent is removed by heating under a reduced pressure; and a solidification method in which the hydrogenated product of the block copolymer is deposited and solidified by pouring the solution into a poor solvent of the hydrogenated product of the block copolymer.

It is preferable that the hydrogenated product of the block copolymer thus collected is processed to be in a shape of pellets so that it is easily subjected to the succeeding molding processing or modification reaction. For example, when the hydrogenated product of the block copolymer is collected from the reaction liquid by the direct solvent removal method, the hydrogenated product in a molten state may be extruded into a strand shape from a die. After cooling, the hydrogenated product of the block copolymer may be cut into a pellet shape by a pelletizer and subjected to a variety of molding. Further, when the solidification method is used, for example, the obtained solidified product may be dried and then extruded by an extruder in a molten state. Then, the hydrogenated product of the block copolymer may be formed into a pellet shape in the same manner as described above and subjected to various types of molding.

### [2. 2. Optional components]

Examples of the optional component, which may be contained in the resin forming the sealing material in combination with the polymer, may include a metal compound. The metal contained in the metal compound includes semimetal. As the metal compound, an inorganic metal compound, an organometallic compound, and a combination thereof may also be used. Of these, a metal compound capable of functioning as a water scavenger is preferable. When the sealing material contains the water scavenger, deterioration of the light-emitting element caused by water can be effectively suppressed.

Examples of the metal compound capable of functioning as the water scavenger may include: an inorganic metal oxide, such as barium oxide (BaO), calcium oxide (CaO), and strontium oxide (SrO); and an organometallic compound described in Japanese Patent Application Laid-Open No. 2005-298598 A. Further, a deliquescent phosphor can function as the water scavenger, and thus such a phosphor may be used as the metal compound. Further, for example, the metal compound capable of physically adsorbing water, such as zeolite, silica gel, and activated alumina, may be used. As the metal compound, one type thereof may be solely used, and two or more types thereof may also be used in combination at any ratio.

The metal compound is usually contained in the resin as particles. The diameter of the metal compound particles may be set depending on transparency required for the sealing material. For example, if the sealing material is required to be transparent, the number-average particle diameter of the metal compound particles is preferably 100 nm or less. Further, for example, if the sealing material is not needed to be transparent, the number-average particle diameter of the metal compound particles may be set to equal to or less than 1/10 the thickness of the sealing material.

The amount of the metal compound is preferably 5 parts by weight or more, more preferably 10 parts by weight or more, and particularly preferably 20 parts by weight or more, and is preferably 90 parts by weight or less, more preferably 80 parts by weight or less, and particularly preferably 70 parts by weight or less, relative to 100 parts by weight of the polymer in the sealing material. When the amount of the metal compound is equal to or more than the lower limit value of the aforementioned range, sufficient water-capturing capability can be obtained. When the amount is equal to or less than the upper limit value of the aforementioned range, the tightness of contact and adhesiveness between the light-emitting element and the sealing material can be enhanced.

Examples of the optional component may include a plasticizer for adjusting the glass transition temperature and the elasticity of the resin forming the sealing material. Examples of the plasticizer may include polyisobutene, hydrogenated polyisobutene, hydrogenated polyisoprene, hydrogenated 1,3-pentadiene-based petroleum resin, hydrogenated cyclopentadiene-based petroleum resin, and hydrogenated styrene-indene-based petroleum resin. As the plasticizer, one type thereof may be solely used, and two or more types thereof may also be used in combination at any ratio.

The amount of the plasticizer is preferably 40 parts by weight or less relative to 100 parts by weight of the resin forming the sealing material, and is appropriately selected in accordance with the purpose for adjusting resin properties.

Examples of the optional component may include a light stabilizer for enhancing weather resistance and heat resistance of the sealing material. As the light stabilizer, hindered amine-based light stabilizers are preferable. Of these, particularly preferable is a compound having a 3,5-di-t-butyl-4-hydroxyphenyl group, a 2,2,6,6-tetramethylpiperidyl group, or a 1,2,2,6,6-pentamethyl-4-piperidyl group in the molecular structure of the light stabilizer descried above.

Specific examples of the light stabilizer may include: a mixed esterification product of 1,2,3,4-butanetetracarboxylic acid, 1,2,2,6,6-pentamethyl-4-piperidinol, and 3,9-bis(2-hydroxy-1,1-dimethylethyl)-2,4,8,10-tetraoxaspiro[5,5]undecane; a polycondensate of 1,6-hexanediamine-N,N'-bis(2,2,6,6-tetramethyl-4-piperidyl) and morpholine-2,4,6-trichloro-1,3,5-triazine;

1-[2-[3-(3,5-di-t-butyl-4-hydroxyphenyl)propionyloxy]ethyl]-4-[3-3,5-di-t-butyl-4-hydroxyphenyl]propionyloxy]-2,2,6,6-tetramethylpiperidine; 2-(3,5-di-t-butyl-4-hydroxybenzyl)-2-n-butylmalonic acid-bis-(1,2,2,6,6-pentamethyl-4-piperidyl); 4-(3-(3,5-di-t-butyl-4-hydroxyphenyl)propionyloxy)-1-(2-(3-(3,5-di-t-butyl-4-hydroxyphenyl)propionyloxy)ethyl)-2,2,6,6-tetramethylpiperidine; 4-(N-(1-benzyl-2-phenylethyl)-N-formylamino)-2,2,6,6-tetramethylpiperidine; 4-(N-(2-(1-pyrrolidyl)ethyl)-N-formylamino)-2,2,6,6-tetramethylpiperidine; 4-(N-(2-(4-morpholinyl)ethyl)-N-formylamino)-2,2,6,6-tetramethyl-N-methylpiperidine; 4-(N-(2-(4-morpholinyl)ethyl)-N-formylamino)-2,2,6,6-tetramethylpiperidine; 4-(N-(2-(diisopropylamino)ethyl)-N-formylamino)-2,2,6,6-tetramethylpiperidine; 4-(N-(2,4,6-trimethylbenzyl)-N-formylamino)-2,2,6,6-tetramethylpiperidine; 4-(N-(3-(2-ethylhexoxy)propyl)-N-formylamino)-2,2,6,6-tetramethylpiperidine; 4-(N-(3,4-(methylenedioxy)benzyl)-N-formylamino)-2,2,6,6-tetramethylpiperidine; 4-(N-(bicyclo[2.2.1]heptyl)-N-formylamino)-2,2,6,6-tetramethylpiperidine;

4-(N-1,2,2-trimethylpropyl-N-formylamino)-2,2,6,6-tetramethylpiperidine; 4-(N-1,3-dimethylbutyl-N-formylamino)-2,2,6,6-tetramethylpiperidine; 4-(N-1-benzylethyl-N-formylamino)-2,2,6,6-tetramethylpiperidine; 4-(N-2,2-dimethylpropyl-N-formylamino)-2,2,6,6-tetramethylpiperidine; 4-(N-2-ethylhexyl-N-formylamino)-2,2,6,6-tetramethylpiperidine; 4-(N-3-methylbutyl-N-formylamino)-2,2,6,6-tetramethylpiperidine; 4-(N-4-hydroxybutyl-N-formylamino)-2,2,6,6-tetramethylpiperidine; 4-(N-i-propyl-N-formylamino)-2,2,6,6-tetramethylpiperidine; 4-(N-t-butyl-N-formylamino)-2,2,6,6-tetramethylpiperidine; 4-(N-isopropylbenzyl-N-formylamino)-2,2,6,6-tetramethylpiperidine, 4-(N-ethoxyethyl-N-formylamino)-2,2,6,6-tetramethylpiperidine; 4-(N-ethoxypropyl-N-formylamino)-2,2,6,6-tetramethylpiperidine; 4-(N-octadecyl-N-formylamino)-2,2,6,6-tetramethylpiperidine; 4-(N-octyl-N-formylamino)-2,2,6,6-tetramethyl-N-methylpiperidine; 4-(N-octyl-N-formylamino)-2,2,6,6-tetramethylpiperidine; 4-(N-chlorobenzyl-N-formylamino)-2,2,6,6-tetramethylpiperidine; 4-(N-diethylaminoethyl-N-formylamino)-2,2,6,6-tetramethylpiperidine; 4-(N-cyclododecyl-N-formylamino)-2,2,6,6-tetramethylpiperidine;

4-(N-cyclohexyl-N-formylamino)-2,2,6,6-tetramethyl-N-methylcarbonylpiperidine; 4-(N-cyclohexyl-N-formylamino)-2,2,6,6-tetramethyl-N-methylpyridine; 4-(N-cyclohexyl-N-formylamino)-2,2,6,6-tetramethylpyridine; 4-(N-cyclopentyl-N-formylamino)-2,2,6,6-tetramethyl-N-methylpiperidine; 4-(N-cyclopentyl-N-formylamino)-2,2,6,6-tetramethylpiperidine; 4-(N-dimethylaminopropyl-N-formylamino)-2,2,6,6-tetramethylpiperidine; 4-(N-decyl-N-formylamino)-2,2,6,6-tetramethyl-N-methylpiperidine; 4-(N-decyl-N-formylamino)-2,2,6,6-tetramethylpiperidine; 4-(N-dodecyl-N-formylamino)-2,2,6,6-tetramethylpiperidine; 4-(N-pyridinylmethyl-N-formylamino)-2,2,6,6-tetramethylpiperidine; 4-(N-phenylethyl-N-formylamino)-2,2,6,6-tetramethyl-N-methylpyridine; 4-(N-phenylethyl-N-formylamino)-2,2,6,6-tetramethylpyridine; 4-(N-butyl-N-formylamino)-2,2,6,6-tetramethyl-N-methylpiperidine; 4-(N-fluorobenzyl-N-formylamino)-2,2,6,6-tetramethylpiperidine; 4-(N-hexyl-N-formylamino)-2,2,6,6-tetramethyl-N-methylpiperidine; 4-(N-hexyl-N-formylamino)-2,2,6,6-tetramethylpiperidine; 4-(N-pentyl-N-formylamino)-2,2,6,6-tetramethyl-N-methylpiperidine; 4-(N-pentyl-N-formylamino)-2,2,6,6-tetramethylpiperidine; 4-(N-methylcyclohexyl-N-formylamino)-2,2,6,6-tetramethylpyridine; 4-(N-methylbenzyl-N-formylamino)-2,2,6,6-tetramethylpiperidine;

4-(N-methoxybenzyl-N-formylamino)-2,2,6,6-tetramethylpiperidine; 4-(formylamino)-2,2,6,6-tetramethyl-N-methylpiperidine; 4-(formylamino)-2,2,6,6-tetramethylpiperidine; 4-[N-(2,2,6,6-tetramethyl-4-piperidyl)-N-formylamino]-2,2,6,6-tetramethyl-N-methylpyridine; 4-[N-(2,2,6,6-tetramethyl-4-piperidyl)-N-formylamino]-2,2,6,6-tetramethylpyridine; N,N',N",N"'-tetrakis-(4,6-bis(butyl-(N-methyl-2,2,6,6-tetramethylpiperidine-4-yl)amino)-triazine-2-yl)-4,7-diazadecane-1,10-amine; N,N'-bis(2,2,6,6-tetramethyl-4-N-methylpiperidyl)-N,N'-diformyl-1,4-xylylenediamine; N,N'-bis(2,2,6,6-tetramethyl-4-N-methylpiperidyl)-N,N'-diformyl-trimethylenediamine; N,N'-bis(2,2,6,6-tetramethyl-4-N-methylpiperidyl)-N,N'-diformyl-hexamethylenediamine; N,N'-bis(2,2,6,6-tetramethyl-4-N-methylpiperidyl)-N,N'-diformyl-ethylenediamine; N,N'-bis(2,2,6,6-tetramethyl-4-piperidyl)-N,N'-diformyl-1,4-xylylenediamine; N,N'-bis(2,2,6,6-tetramethyl-4-piperidyl)-N,N'-diformylethylenediamine; N,N'-bis(2,2,6,6-tetramethyl-4-piperidyl)-N,N'-diformyl-trimethylenediamine; N,N'-bis(2,2,6,6-tetramethyl-4-piperidyl)-N,N'-diformylhexamethylenediamine; N,N'-bis(2,2,6,6-tetramethyl-4-piperidyl)-N,N'-bishexamethylene acrylic acid amide; N,N'-bis(2,2,6,6-tetramethyl-4-piperidyl)-N,N'-bishexamethylene arachic acid amide; N,N'-bis(2,2,6,6-tetramethyl-4-piperidyl)-N,N'-bishexamethylene angelic acid amide; N,N'-bis(2,2,6,6-tetramethyl-4-piperidyl)-N,N'-bishexamethylene undecylic acid amide;

N,N'-bis(2,2,6,6-tetramethyl-4-piperidyl)-N,N'-bishexamethylene undecylenic acid amide; N,N'-bis(2,2,6,6-tetramethyl-4-piperidyl)-N,N'-bishexamethylene oleic acid amide; N,N'-bis(2,2,6,6-tetramethyl-4-piperidyl)-N,N'-bishexamethylene gadoleic acid amide; N,N'-bis(2,2,6,6-tetramethyl-4-piperidyl)-N,N'-bishexamethylene caprylic acid amide; N,N'-bis(2,2,6,6-tetramethyl-4-piperidyl)-N,N'-bishexamethylene capric acid amide; N,N'-bis(2,2,6,6-tetramethyl-4-piperidyl)-N,N'-bishexamethylene caproic acid amide; N,N'-bis(2,2,6,6-tetramethyl-4-piperidyl)-N,N'-bishexamethylene crotonic acid amide; N,N'-bis(2,2,6,6-tetramethyl-4-piperidyl)-N,N'-bishexamethylene citronellic acid amide; N,N'-bis(2,2,6,6-tetramethyl-4-piperidyl)-N,N'-bishexamethylene stearic acid amide; N,N'-bis(2,2,6,6-tetramethyl-4-piperidyl)-N,N'-bishexamethylene zoomaric acid amide; N,N'-bis(2,2,6,6-tetramethyl-4-piperidyl)-N,N'-bishexamethylene tridecylic acid amide; N,N'-bis(2,2,6,6-tetramethyl-4-piperidyl)-N,N'-bishexamethylene nonadecylic acid amide; N,N'-bis(2,2,6,6-tetramethyl-4-piperidyl)-N,N'-bishexamethylene palmitic acid amide; N,N'-bis(2,2,6,6-tetramethyl-4-piperidyl)-N,N'-bishexamethylene brenzterebic acid amide;

N,N'-bis(2,2,6,6-tetramethyl-4-piperidyl)-N,N'-bishexamethylene propionic acid amide; N,N'-bis(2,2,6,6-tetramethyl-4-piperidyl)-N,N'-bishexamethylene heptanoic acid amide; N,N'-bis(2,2,6,6-tetramethyl-4-piperidyl)-N,N'-bishexamethylene behenic acid amide; N,N'-bis(2,2,6,6-tetramethyl-4-piperidyl)-N,N'-bishexamethylene pelargonic acid amide; N,N'-bis(2,2,6,6-tetramethyl-4-piperidyl)-N,N'-bishexamethylene pentadecylic acid amide; N,N'-bis(2,2,6,6-tetramethyl-4-piperidyl)-N,N'-bishexamethylene margaric acid amide; N,N'-bis(2,2,6,6-tetramethyl-4-piperidyl)-N,N'-bishexamethylene myristic acid amide; N,N'-bis(2,2,6,6-tetramethyl-4-piperidyl)-N,N'-bishexamethylene lauric acid amide; N,N'-bis(2,2,6,6-tetramethyl-4-piperidyl)-N,N'-bishexamethylene linderic acid amide; N,N'-bis(2,2,6,6-tetramethyl-4-piperidyl)-N,N'-bishexamethylene valeric acid amide; N,N'-bis(2,2,6,6-tetramethyl-4-piperidyl)-N,N'-bishexamethylene acetic acid amide; N,N'-bis(2,2,6,6-tetramethyl-4-piperidyl)-N,N'-bishexamethylene myristic acid amide; N,N'-bis(2,2,6,6-tetramethyl-4-piperidyl)-N,N'-bishexamethylene butyric acid amide; a polymer of dimethyl succinate and 4-hydroxy-2,2,6,6-tetramethyl-1-piperidineethanol; a polycondensate of dibutylamine, 1,3,5-triazine, and N,N'-bis(2,2,6,6-tetramethyl-4-piperidyl)butylamine;

bis(1,2,2,6,6-pentamethyl-4-piperidyl)-2-(3,5-dit-butyl-4-hydroxybenzyl)-2-n-butylmalonate; bis(2,2,6,6-tetramethyl-4-piperidyl)sebacate; poly[(6-morpholino-s-triazine-2,4-diyl)[(2,2,6,6-tetramethyl-4-piperidyl)imino]-hexamethylene[(2,2,6,6-tetramethyl-4-piperidyl)imino]; poly[{(1,1,3,3-tetramethylbutyl)amino-1,3,5-triazine-2,4-diyl}{(2,2,6,6-tetramethyl-4-piperidyl)imino}hexamethylene{(2,2,6,6-tetramethyl-4-piperidyl)imino}]; poly[{6-(1,1,3,3-tetramethylbutyl)amino-1,3,5-triazine-2,4-diyl}{(2,2,6,6-tetramethyl-4-piperidyl)imino}hexamethylene{(2,2,6,6-tetramethyl-4-piperidyl)imino}]; and a reaction product of a polymer of N,N'-bis(2,2,6,6-tetramethyl-4-piperidinyl)-1,6-hexadiamine and 2,4,6-trichloro-1,3,5-triazine, N-butyl-1-butanamine, and N-butyl-2,2,6,6-tetramethyl-4-piperidineamine.

Of these, N,N'-bis(2,2,6,6-tetramethyl-4-N-methylpiperidyl)-N,N'-diformyl-alkylenediamines; N,N'-bis(2,2,6,6-tetramethyl-4-piperidyl)-N,N'-diformylalkylenediamines; N,N'-bis(2,2,6,6-tetramethyl-4-piperidyl)-N,N'-bisalkylene fatty acid amides; and poly[{6-(1,1,3,3-tetramethylbutyl)amino-1,3,5-triazine-2,4-diyl}{(2,2,6,6-tetramethyl-4-piperidyl)imino}hexamethylene{(2,2,6,6-tetramethyl-4-piperidyl)imino}] are preferable from the viewpoint of excellent weather resistance, and N,N'-bis(2,2,6,6-tetramethyl-4-piperidyl)-N,N'-diformylalkylenediamines and the reaction product of the polymer of N,N'-bis(2,2,6,6-tetramethyl-4-piperidinyl)-1,6-hexanediamine and 2,4,6-trichloro-1,3,5-triazine, N-butyl-1-butanamine, and N-butyl-2,2,6,6-tetramethyl-4-piperidineamine are particularly preferable. As the light stabilizer, one type thereof may be solely used, and two or more types thereof may also be used in combination at any ratio.

The amount of the light stabilizer is preferably 0.01 parts by weight or more, more preferably 0.02 parts by weight or more, and particularly preferably 0.03 parts by weight or more, and is preferably 5 parts by weight or less, more preferably 2 parts by weight or less, and particularly preferably 1 part by weight or less, relative to 100 parts by weight of the polymer in the sealing material. When the amount of the light stabilizer is equal to or more than the lower limit value of the aforementioned range, weather resistance of the sealing material can be enhanced. Further, when the amount is equal to or less than the upper limit value, smear of the T-die and the cooling roll of the extruder can be prevented in producing the sealing material by molding the resin, thereby enabling to improve the processability.

Examples of the optional component may include an ultraviolet ray absorber. Examples of the ultraviolet ray absorber may include a benzophenone-based ultraviolet ray absorber, a salicylic acid-based ultraviolet ray absorber, and a benzotriazole-based ultraviolet ray absorber.

Examples of the benzophenone-based ultraviolet ray absorber may include 2,4-dihydroxybenzophenone, 2-hydroxy-4-methoxybenzophenone, 2-hydroxy-4-methoxybenzophenone-5-sulfonic acid trihydrate, 2-hydroxy-4-octyloxybenzophenone, 4-dodecaloxy-2-hydroxybenzophenone, 4-benzyloxy-2-hydroxybenzophenone, 2,2',4,4'-tetrahydroxybenzophenone, and 2,2'-dihydroxy-4,4'-dimethoxybenzophenone.

Examples of the salicylic acid-based ultraviolet ray absorber may include phenyl salicylate, 4-t-butylphenyl-2-hydroxybenzoate, phenyl-2-hydroxybenzoate, 2,4-di-t-butylphenyl-3,5-di-t-butyl-4-hydroxybenzoate, and hexadecyl-3,5-di-t-butyl-4-hydroxybenzoate.

Examples of the benzotriazole-based ultraviolet ray absorber may include 2-(2-hydroxy-5-methylphenyl)2H-benzotriazole, 2-(3-t-butyl-2-hydroxy-5-methylphenyl)-5-chloro-2H-benzotriazole, 2-(3,5-di-t-butyl-2-hydroxyphenyl)-5-chloro-2H-benzotriazole, 2-(3,5-di-t-butyl-2-hydroxyphenyl)-2H-benzotriazole, 5-chloro-2-(3,5-di-t-butyl-2-hydroxyphenyl)-2H-benzotriazole, 2-(3,5-di-t-amyl-2-hydroxyphenyl)-2H-benzotriazole, 2-(2-hydroxy-5-t-octylphenyl)-2H-benzotriazole, 2-(2-hydroxy-4-octylphenyl)-2H-benzotriazole, 2-(2H-benzotriazol-2-yl)-4-methyl-6-(3,4,5,6-tetrahydrophthalimidylmethyl)phenol, and 2,2'-methylenebis[4-(1,1,3,3-tetramethylbutyl)-6-[(2H-benzotriazol-2-yl)phenol]].

As the ultraviolet ray absorber, one type thereof may be solely used, and two or more types thereof may also be used in combination at any ratio.

The amount of the ultraviolet ray absorber is preferably 0.01 parts by weight or more, more preferably 0.02 parts by weight or more, and particularly preferably 0.04 parts by weight or more, and is preferably 1 part by weight or less, more preferably 0.75 parts by weight or less, and particularly preferably 0.5 parts by weight or less, relative to 100 parts by weight of the polymer in the sealing material. When the using amount of the ultraviolet ray absorber is equal to or more than the lower limit value of the aforementioned range, light resistance of the sealing material can be improved. On the other hand, excessive use beyond the upper limit does not tend to bring about any further improvement.

Examples of the optional component may include an antioxidant. Examples of the antioxidant may include a phosphorus-based antioxidant, a phenol-based antioxidant, and a sulfur-based antioxidant. The phosphorus-based antioxidant causes less coloration and thus is preferable.

Examples of the phosphorus-based antioxidant may include: monophosphite compounds such as triphenyl phosphite, diphenylisodecyl phosphite, phenyldiisodecyl phosphite, tris(nonylphenyl) phosphite, tris(dinonylphenyl) phosphite, tris(2,4-di-t-butylphenyl) phosphite, and 10-(3,5-di-t-butyl-4-hydroxybenzyl)-9,10-dihydro-9-oxa-10-phosphaphenanthrene-10-oxide; diphosphite compounds such as 4,4'-butylidene-bis(3-methyl-6-t-butylphenyl-di-tridecyl phosphite) and 4,4'-isopropylidene-bis(phenyl-di-alkyl(C12-C15) phosphite); and compounds such as 6-[3-(3-t-butyl-4-hydroxy-5-methylphenyl)propoxy]-2,4,8,10-tetrakis-t-butyldibenzo[d,f][1.3.2]dioxaphosphepine and 6-[3-(3,5-dit-butyl-4-hydroxyphenyl)propoxy]-2,4,8,10-tetrakis-t-butyldibenzo[d,f][1.3.2]dioxaphosphepine.

Examples of the phenol-based antioxidant may include compounds such as pentaerythrityl·tetrakis[3-(3,5-di-t-butyl-4-hydroxyphenyl) propionate], 2,2-thio-diethylenebis[3-(3,5-di-t-butyl-4-hydroxyphenyl) propionate], octadecyl-3-(3,5-di-t-butyl-4-hydroxyphenyl) propionate, 3,9-bis{2-[3-(3-t-butyl-4-hydroxy-5-methylphenyl) propionyloxy]-1,1-dimethylethyl}-2,4,8,10-tetraoxaspiro[5,5]undecane, and 1,3,5-trimethyl-2,4,6-tris(3,5-di-t-butyl-4-hydroxybenzyl)benzene.

Examples of the sulfur-based antioxidant may include compounds such as dilauryl-3,3'-thiodipropionate, dimyristyl-3,3'-thiodipropionate, distearyl-3,3'-thiodipropionate, laurylstearyl-3,3'-thiodipropionate, pentaerythritol-tetrakis-(β-lauryl-thio-propionate), and 3,9-bis(2-dodecylthioethyl)-2,4,8,10-tetraoxaspiro[5,5]undecane.

As the antioxidant, one type thereof may be solely used, and two or more types thereof may also be used in combination at any ratio.

The amount of the antioxidant is preferably 0.01 parts by weight or more, more preferably 0.05 parts by weight or more, and particularly preferably 0.1 parts by weight or more, and is preferably 1 part by weight or less, more preferably 0.5 parts by weight or less, and particularly preferably 0.3 parts by weight or less, relative to 100 parts by weight of the polymer in the sealing material. When the using amount of the antioxidant is equal to or more than the lower limit value of the aforementioned range, heat stability of the sealing material can be improved. On the other hand, excessive use beyond the upper limit does not tend to bring about any further improvement.

Further, examples of the optional component other than the ones described above may include a lubricant and an inorganic filler. As the optional component, one type thereof may be solely used, and two or more types thereof may also be used in combination at any ratio.

Examples of the method for obtaining the resin for forming the sealing material by mixing the polymer and the optional component may include: a method in which the optional component is dissolved in an appropriate solvent and mixed with a solution of the polymer, and then a desired resin is collected by removing the solvent; and a method in which the polymer is brought into a molten state and kneaded with the optional component using a kneader, such as a twin-screw kneader, a roll, a Brabender, and an extruder.

### [2. 3. Properties of resin]

The resin forming the sealing material is preferably transparent. By using the sealing material formed of the transparent resin, the sealing material can be provided at a portion through which the light emitted from the light-emitting element passes. The transparent resin described herein refers to a resin having the total light transmittance measured for a sample piece of the resin having a thickness of 1 mm of usually 70% or more, preferably 80% or more, and more preferably 90% or more. Further, the total light transmittance may be measured using an ultraviolet and visible spectrophotometer in a wavelength range from 400 nm to 700 nm.

The glass transition temperature of the resin forming the sealing material is preferably 30°C or higher, more preferably 50°C or higher, and particularly preferably 70°C or higher, and is preferably 200°C or lower, more preferably 180°C or lower, and particularly preferably 160°C or lower. When the resin containing the block copolymer is used, the resin may have a plurality of glass transition temperatures. In such a case, it is preferable that the highest glass transition temperature of the resin falls within the aforementioned range. When the glass transition temperature of the resin forming the sealing material falls within the aforementioned range, adhesiveness of the sealing material and maintenance of the properties of the light-emitting element after sealing can be balanced well.

### [3. Properties and thickness of sealing material]

The sealing material is preferably flexible. The flexible sealing material can deform to absorb external force that is applied to the light-emitting device, thereby enabling to prevent breakage of the light-emitting element due to the external force. This can achieve flexibility of the light-emitting device. Further, when the light-emitting element is sealed by the sealing material, the sealing material can be easily deformed in conformity with a shape of the surface of the light-emitting element. Thus, this makes it easy to bring the sealing material into tight contact with the light-emitting element without any gap, thereby enabling effective suppression of the occurrence of air bubbles. Specifically, the tensile elastic modulus of the sealing material is preferably 1,500 MPa or lower, more preferably 1,000 MPa or lower, and particularly preferably 800 MPa or lower. The tensile elastic modulus is a value measured at 23°C. Although the lower limit of the aforementioned tensile elastic modulus is not particularly limited, it is preferably 0.1 MPa or higher.

The storage elastic modulus of the sealing material at 90°C is preferably 10 MPa or higher, more preferably 20 MPa or higher, and particularly preferably 50 MPa or higher. By having the storage elastic modulus of the sealing material at 90°C as high as described above, durability of the sealing material can be enhanced, and reduction in the sealing capability particularly in a high temperature environment can be effectively suppressed. Although the upper limit of the storage elastic modulus of the sealing material at 90°C is not particularly limited, it is preferably 1,000 MPa or lower.

The transparency of the sealing material is not particularly limited. However, it is preferable that the sealing material has high transparency from the viewpoint of making the sealing material useful for use as a part where the light transmission is required. In such a case, the total light transmittance of the sealing material is preferably 70% or more, more preferably 80% or more, and particularly preferably 90% or more.

The haze of the sealing material is not particularly limited. However, when the sealing material is used for an optical application that is not particularly intended to diffuse light, it is generally preferable that the haze of the sealing material is low. In such a case, the haze of the sealing material is preferably 3.0% or less, and more preferably 1.0% or less. The haze may be measured according to JIS K 7136 with a film piece of 50mm x 50mm obtained by cutting out the sealing material.

It is preferable that, when the sealing material is bonded to another member, the sealing material exhibits excellent adhesiveness to the member. In particular, it is preferable that the sealing material has sufficiently high adhesiveness to an inorganic substance, since the sealing material is often brought into contact with a portion formed of an inorganic substance, such as an electrode of the light-emitting element and a barrier layer of the barrier member, in the light-emitting device. For example, when the sealing material is directly bonded to a glass plate, the peeling strength required to peel the sealing material from the glass plate is preferably 5 N/cm or more, and more preferably 10 N/cm or more. Although the upper limit of the aforementioned peeling strength is not particularly limited, it is preferably 200 N/cm or less.

The thickness of the sealing material is preferably 10 µm or more, more preferably 15 µm or more, further preferably 17 µm or more, and particularly preferably 20 µm or more, and is preferably 500 µm or less, more preferably 200 µm or less, further preferably 150 µm or less, and particularly preferably 100 µm or less. When the thickness of the sealing material is equal to or more than the lower limit value of the aforementioned range, production of the sealing material is facilitated. Further, the sealing material with a thickness of this extent can provide a sufficient sealing function. In addition, even if the sealing material is contaminated with a small foreign matter, unevenness in the thickness of the sealing material due to the foreign matter can be suppressed. Further, when the thickness of the sealing material is equal to or less than the upper limit value, deflection of the light-emitting device can be suppressed, and also the thickness of the light-emitting device can be reduced.

### [4. Method for producing sealing material]

There is no limitation to the method for producing the sealing material. For example, when a sealing material in a shape of a film is produced, the production may be performed by a production method including a step of molding a resin for forming the sealing material in a desired shape to obtain a resin film, and a step of processing a surface of the obtained resin film to form a bonding surface having the arithmetic average roughness Ra in a desired range.

As the method for molding the resin, for example, a melt molding method, a solution casting method, or the like may be used. In more detail, the melt molding method may be classified into an extrusion molding method, a press molding method, an inflation molding method, an injection molding method, a blow molding method, a stretch molding method, and the like. Of these, the extrusion molding method, the inflation molding method, and the press molding method are preferably employed for obtaining the sealing material having excellent mechanical strength and surface precision. Even among them, the extrusion molding method is particularly preferable form the viewpoint of producing the resin film in an efficient and simple manner.

As the method for processing the surface of the resin film to form the bonding surface having the arithmetic average roughness Ra in a desired range, any method capable of roughening the surface of the resin film may be employed. Specific examples of an aspect of the processing may include emboss processing. In the emboss processing, the surface of the resin film is pressed by a rough surface of the emboss die having the rough surface optionally with heating. In this manner, a shape of the rough surface of the emboss die is transferred to the pressed surface of the resin film, so that a boding surface having the desired arithmetic average roughness Ra is formed on the resin film and, as a result, the sealing material is obtained. There is no limitation to the emboss die, and any die, such as an emboss plate having a plate shape, an emboss roll having a cylindrical shape, and an emboss ring having a ring shape, may be used.

### [5. Sealing of light-emitting element using sealing material]

The sealing material described above is used for sealing the light-emitting element. When the light-emitting element is sealed by the sealing material, the sealing is performed by bonding the bonding surface of the sealing material to the light-emitting element. When the bonding described above is performed, usually the bonding surface side of the sealing material is placed on the surface of the light-emitting element to align them, and then the sealing material is press-bonded to the light-emitting element at a specific sealing temperature. By this process, the bonding surface of the sealing material is in tight contact with the light-emitting element to achieve sealing of the light-emitting element. In this process, as the bonding surface of the sealing material has the appropriate arithmetic average roughness Ra, sealing of the light-emitting element can be achieved while suppressing the occurrence of the air bubbles and the dark spots. This configuration can stably protect the elements constituting the light-emitting element from water and oxygen, and thereby properties of the light-emitting element can be maintained for a long period of time.

Further, when the light-emitting element is sealed by the sealing material described above, a barrier member capable of covering the light-emitting element is usually bonded to the surface of the sealing material on the side opposite to light-emitting element. In this manner, water and oxygen are blocked not only by the sealing material, but also by the barrier member, and thus the light-emitting element can be sealed at a higher level.

When the barrier member is used, the sealing material is usually disposed between the light-emitting element and the barrier member to form a tight-contact sealing structure. The tight-contact sealing structure described herein refers to a structure in which the light-emitting element and the sealing material are in tight contact with each other and the sealing material and the barrier member are in tight contact with each other, whereby the air is prevented from being present between the light-emitting element and the barrier member. With such a tight-contact sealing structure, sealing at a higher level can be achieved, and a light-emitting device having flexibility can be realized.

The bonding of the sealing material and the barrier member is usually performed by stacking the sealing material and the barrier member and press-bonding the sealing material and the barrier member at a specific sealing temperature. The bonding of the sealing material and the barrier member may be performed before bonding the sealing material to the light-emitting element, and may also be performed after boding the sealing material to the light-emitting element. However, it is preferably performed at the same time as the boding of the sealing material to the light-emitting element from the viewpoint of reducing the number of processes.

### [5. 1. Sealing conditions]

The sealing is usually performed at a temperature higher than the glass transition temperature of the resin contained in the sealing material. The specific sealing temperature is preferably (Tg + 5)°C or higher, more preferably (Tg + 10)°C or higher, and particularly preferably (Tg + 20)°C or higher. The term "Tg" descried herein represents the glass transition temperature of the resin forming the sealing material. When the resin forming the sealing material has a plurality of glass transition temperatures, Tg described above represents the highest glass transition temperature among the plurality of glass transition temperatures. The sealing material is sufficiently flexible at such a temperature higher than the glass transition temperature. Thus, even if the surface of the light-emitting element is not flat, the sealing material is easily brought into tight contact with the element surface without a gap, and thus the excellent sealing can be achieved. In particular, when the light-emitting element to be provided on a display surface of a display device is sealed by the sealing material described above, minute concave and convex portions on the display surface can be reduced by the sealing material, and thus display appearance can be improved. The upper limit of the sealing temperature is preferably (Tg + 150)°C or lower, more preferably (Tg + 120)°C or lower, particularly preferably (Tg + 100)°C or lower. With such a temperature, thermal deterioration of the light-emitting element caused by heating during the sealing can be suppressed.

The pressure applied for the press-bonding is preferably 0.01 MPa or higher, more preferably 0.05 MPa or higher, and particularly preferably 0.1 MPa or higher, and is preferably 1 MPa or lower, more preferably 0.75 MPa or lower, and particularly preferably 0.5 MPa or lower. When the pressure is equal to or more than the lower limit value of the aforementioned range, the sealing material can be easily brought into tight contact with the light-emitting element. Further, when the pressure is equal to or less than the upper limit value of the aforementioned range, occurrence of the dark spots can be effectively suppressed.

It is preferable to perform the aforementioned sealing in an environment of reduced pressure. This can further effectively suppress intrusion of water and oxygen into the light-emitting element to be sealed. The specific degree of vacuum in the sealing environment is preferably 100 Pa or lower, more preferably 75 Pa or lower, and particularly preferably 50 Pa or lower.

It is also preferable to perform the aforementioned sealing in a dry room in which dry air having a dew point temperature of -40°C or lower is introduced. This can further effectively suppress the intrusion of water and oxygen into the light-emitting element to be sealed.

### [5. 2. Light-emitting element]

There is no particular limitation to the light-emitting element as the subject to be sealed by the sealing material. The light-emitting element generally includes a light-emitting layer and electrodes for supplying electric charges to the light emitting layer, and the light-emitting layer emits light as a result of the supply of the electric charges from the electrodes. Further, the light-emitting element usually includes a substrate, on which the light-emitting layer and electrodes described above are provided. As the light-emitting element to be sealed by the sealing material described above, an organic light-emitting element is preferable in terms of effectively utilizing the excellent sealing capability of the aforementioned sealing material. The organic light-emitting element herein refers to a light-emitting element including an organic light-emitting layer. Further, the organic light-emitting layer refers to a light-emitting layer containing an organic compound. Examples of the organic light-emitting element may include an organic EL element. The organic EL element is thin in thickness and can be made flexible, and thus is an excellent light-emitting element.

Examples of the substrate of the organic EL element may include: a flexible substrate formed of a flexible transparent plastic, such as polycarbonate, polyethylene terephthalate, polyethylene naphthalate, and an alicyclic olefin polymer; and a glass substrate, such as a quartz glass, a soda glass, and an inorganic alkali glass.

Examples of the electrode for use may include: a transparent electrode formed of a thin metal film, ITO, IZO, SnO₂, or the like; and a reflection electrode formed of aluminum, MgAg, or the like. The light-emitting element usually includes an anode and a cathode as the electrodes, and the transparent electrode is adopted for at least one of them. By having this configuration, the light-emitting element can achieve light emission through the transparent electrode. In this case, the counter electrode of the transparent electrode described above may be a transparent electrode, however it is preferably a reflection electrode.

No particular limitation is imposed on the light-emitting layer, and any known light-emitting layer may be appropriately selected. Further, in order to adapt to the use as the light source, the light-emitting layer may be configured to emit light containing a desired peak wavelength by having one type of single layer or a combination of a plurality of types of layers.

Further, the light-emitting element may include an optional layer in addition to the aforementioned substrate, electrodes and light-emitting layer. For example, the light-emitting element may further include the optional layer between the anode and the cathode, such as a hole injection layer, a hole transport layer, an electron transport layer, an electron injection layer, and a gas barrier layer.

Specific examples of the layer configuration of the light-emitting element may include: a configuration of anode / hole transport layer / light-emitting layer / cathode; a configuration of anode / hole transport layer / light-emitting layer / electron injection layer / cathode; a configuration of anode / hole injection layer / light-emitting layer / cathode; a configuration of anode / hole injection layer / hole transport layer / light-emitting layer / electron transport layer / electron injection layer / cathode; a configuration of anode / hole transport layer / light-emitting layer / electron injection layer / equipotential surface forming layer / hole transport layer / light-emitting layer / electron injection layer / cathode; and a configuration of anode / hole transport layer / light-emitting layer / electron injection layer / charge generation layer / hole transport layer / light-emitting layer / electron injection layer / cathode. The light-emitting element may be configured to include one or more light-emitting layers between the anode and the cathode. Such light-emitting layers may have a laminate of a plurality of layers having different light emission colors or a mixed layer in which a layer having a certain coloring agent is doped with a different coloring agent. Examples of the material constituting the light-emitting layers may include polyparaphenylene vinylene-based, polyfluorene-based, and polyvinylcarbazole-based materials. Further, examples of the materials of the hole injection layer and the hole transport layer may include phthalocyanine-based, arylamine-based, and polythiophene-based materials. Examples of the materials of the electron injection layer and the electron transport layer may include an aluminum complex and lithium fluoride. Examples of the materials of the equipotential surface forming layer and the charge generation layer may include a transparent electrode, such as ITO, IZO, and SnO₂ and a thin metal film, such as Ag and Al.

The electrodes, the light-emitting layer, and other optional layers may be disposed, for example, by sequentially forming these layers on the substrate. The formation of each layer is usually performed in a reduced pressure environment. The thicknesses of the respective layers may be set to 10 nm to 1,000 nm.

The light-emitting element may further include an optional component, such as a wiring, for applying electricity to the electrodes.

### [5. 3. Barrier member]

As the barrier member, a film is usually used. Such a barrier member may have a single layer structure including only one layer or a multilayered structure including two or more layers. Of these, as the barrier member, a film having a multilayered structure including a substrate film layer and a barrier layer is preferable.

As the substrate film layer, a resin film is usually used. In particular, a transparent resin is preferably used from the viewpoint of making the barrier member useful for use as a part where light transmission is required in the display device and the light source device.

Further, as the resin forming the substrate film layer, for example, any of a thermoplastic resin, a thermosetting resin, an ultraviolet light-curable resin, and an electron beam curable resin may be used. Of these, the thermoplastic resin is easily processed and thus is preferable. Examples of the thermoplastic resin may include a polyester resin, a polyacrylate resin, and an olefin resin.

Of these, as the substrate film layer, a film formed of an alicyclic olefin resin is preferably used. The alicyclic olefin resin is a resin containing an alicyclic olefin polymer and, if necessary, an optional component other than the alicyclic olefin polymer. The alicyclic olefin resin has low hygroscopicity and excellent mechanical strength. Further, the alicyclic olefin resin releases less outgas in the processes such as vapor deposition and sputtering at the time of forming the barrier layer. Thus, using the film formed of the alicyclic polyolefin resin as the substrate film layer can enhance the sealing capability of the barrier member. In particular, the substrate film layer produced by melt extrusion of the alicyclic olefin resin has excellent surface smoothness and has smaller surface protrusions that may cause cracks in the barrier layer, and thus there is no need for increasing the thickness of the barrier layer to obtain the barrier layer that can exhibit the high sealing capability. Accordingly, such a substrate film layer is excellent in productivity and flexibility.

Examples of the alicyclic olefin resin may include a norbornene-based resin, a monocyclic olefin resin, a cyclic conjugated diene resin, and a vinyl alicyclic hydrocarbon resin. Of these, the norbornene-based resin is excellent in transparency and formability and can thus be preferably used.

The resin forming the substrate film layer preferably has the high glass transition temperature. The specific glass transition temperature of the resin forming the substrate film layer is preferably 110°C or higher, more preferably 130°C or higher, and particularly preferably 160°C or higher. The resin having the high glass transition temperature has low tendency to cause thermal shrinkages due to temperature changes, and thus the reduction in the sealing capability of the barrier member in a high temperature environment can be suppressed. The upper limit of the glass transition temperature of the resin forming the substrate film layer is not particularly limited, but it is preferably set to 300°C or lower.

The substrate film layer may have a single layer structure consisting of only one layer or a multilayered structure including two or more layers.

The thickness of the substrate film layer is preferably 10 µm or more, and more preferably 30 µm or more, and is preferably 500 µm or less, and more preferably 250 µm or less. The substrate film layer having such a thickness is excellent in mechanical strength and sealing capability in a well-balanced manner.

The substrate film layer may be produced by any methods. For example, when the substrate film layer is produced from a thermoplastic resin, the substrate film layer may be produced by molding the resin into a film shape by a melt molding method, a solution casting method, or the like. In more detail, the melt molding method may be classified into, for example, an extrusion molding method, a press molding method, an inflation molding method, an injection molding method, a blow molding method, a stretch molding method, and the like. Of these, the extrusion molding method, the inflation molding method, or the press molding method is preferably employed for obtaining the substrate film layer having excellent mechanical strength and surface precision. Even among them, the extrusion molding method is particularly preferable for producing the substrate film layer in an efficient and simple manner. Further, the production of the substrate film layer may include a stretching step for stretching the film.

The barrier layer is a layer capable of blocking water or oxygen. The barrier layer is usually formed by an inorganic material. Examples of the preferable inorganic material may include: metal (including semimetal); a metal compound such as a metal oxide, a metal nitride, and a metal oxynitride; and DLC (diamond-like carbon). Example of the aforementioned metal may include aluminum, and silicon. Of these inorganic materials, the material containing at least silicon, such as a silicon oxide, a silicon nitride, and a silicon oxynitride, is particularly preferable in terms of transparency.

Examples of the silicon oxide may include SiOₓ. In this chemical formula, x is a numeric value preferably greater than 1.4, and more preferably greater than 1.5, and preferably smaller than 2.0, and more preferably small than 1.9 from the viewpoint of achieving both the transparency and sealing capability of the barrier layer. Further, examples of the silicon oxide may also include SiOC.

Examples of the silicon nitride may include SiN_{y}. In this chemical formula, y is a numeric value preferably greater than 0.5, and more preferably greater than 1.2, and preferably smaller than 1.5 from the viewpoint of achieving both the transparency and sealing capability of the barrier layer.

Examples of the silicon oxynitride may include SiOₚN_{q}. In the case where priority is put on an improvement in the tight contact of the barrier layer, p and q in the chemical formula are preferably set to 1 < p < 2.0 and 0 < q < 1.0, respectively, to make the barrier layer an oxygen-rich film. Further, in the case where priority is put on an improvement in the sealing capability of the barrier layer, p and q are preferably set to 0 < p < 0.8 and 0.8 < q < 1.3, respectively, to make the barrier layer a nitrogen-rich film.

Examples of the aluminum oxide, the aluminum nitride, and the aluminum oxynitride may include AlOₓ, AlN_{y}, and AlOₚN_{q}.

Of these, SiOpNq and AlOₓ are preferable from the viewpoint of enhancing sealing capability.

As the inorganic material, one type thereof may be solely used, and two or more types thereof may also be used in combination at any ratio.

The thickness of the barrier layer is preferably 3 nm or more, more preferably 10 nm or more, and particularly preferably 100 nm or more, and is preferably 2,500 nm or less, more preferably 2,000 nm or less, and particularly preferably 1,000 nm or less. When the thickness of the barrier layer is equal to or more than the lower limit value of the aforementioned range, sealing capability can be exhibited at a high level. When the thickness is equal to or less than the upper limit value, coloration of the barrier layer can be suppressed while maintaining sufficient sealing capability.

The barrier layer may be formed by any methods. For example, when the barrier layer is formed by the inorganic material, forming methods such as a vapor deposition method, a sputtering method, an ion plating method, an ion beam assist vapor deposition method, an arc discharge plasma vapor deposition method, a heat CVD method, and a plasma CVD method, may be used. Of these, using the arc discharge plasma vapor deposition method allows to produce evaporation particles having proper energy and form a high-density film. Further, when a chemical vapor deposition method, such as the heat CVD method and the plasma CVD method, is used, the flexible barrier layer can be formed by adjusting a gas component used in the formation of the film, and thus, cracks in the barrier layer can be effectively suppressed. Further, when the barrier layer containing a plurality of types of the components is formed, these components may be subjected to the vapor deposition or the sputtering simultaneously.

Further, the barrier member may contain an optional layer in combination with the aforementioned substrate film layer and barrier layer. Examples of the optional layer may include a blocking preventing layer, an antistatic layer, a hard coat layer, a electroconductivity-imparting layer, a contamination preventing layer, and a concavo-convex structural layer.

### [6. Light-emitting device]

The light-emitting device, in which the occurrence of air bubbles and dark spots is suppressed, may be produced by sealing the light-emitting element using the aforementioned sealing material. For example, the light-emitting device having a tight-contact sealing structure may be produced by a production method including a step of bonding the bonding surface of the sealing material to the light-emitting element and a step of boding the barrier member to the surface of the sealing material on the side opposite to the bonding surface described above.

The light-emitting device thus produced includes the light-emitting element, the sealing material, and the barrier member in this order, and the light-emitting element is sealed by the sealing material and the barrier member. Further, in this light-emitting device, the light-emitting element and the sealing material are in tight contact without forming air bubbles, and the sealing material and the barrier member are usually in tight contact without forming air bubbles. Further, in this light-emitting device, the light-emitting element is hardly damaged at the time of sealing, and thus dark spots are hardly generated. As a result, the aforementioned light-emitting device can realize uniform light emission on the light emitting surface.

In the following, a description will be given of embodiments of such a light-emitting device.

### [6. 1. First embodiment]

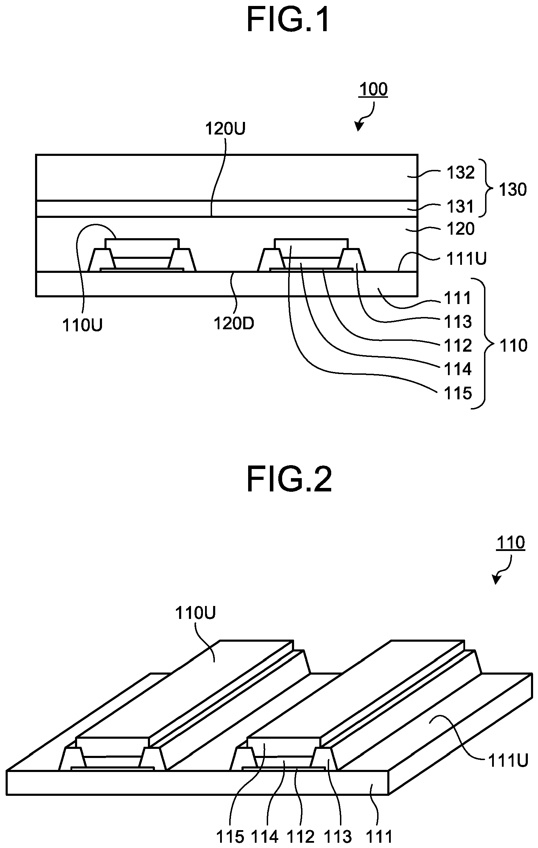

FIG. 1 is a vertical cross-sectional view schematically illustrating a light-emitting device 100 according to a first embodiment of the present invention. Further, FIG. 2 is a perspective view schematically illustrating an organic EL element 110 contained in the light-emitting device 100 according to the first embodiment of the present invention.

As shown in Fig. 1, the light-emitting device 100 according to the first embodiment of the present invention includes an organic EL element 110 as the light-emitting element, a sealing material 120, and a barrier member 130 in this order.

As shown in Fig. 2, the organic EL element 110 includes a substrate 111, a large number of first electrodes 112 formed in an elongated stripe form on an upper surface 111U of the substrate 111, edge cover layers 113 formed on the peripheries of the first electrodes 112, light emitting layers 114 disposed on the first electrodes 112, and second electrodes 115 disposed on the light emitting layers 114. In the organic EL element 110 having such a configuration, the light emitting layers 114 can emit light by applying electricity to the first electrodes 112 and the second electrodes 115.

As shown in Fig. 1, a bonding surface 120D of the sealing material 120 is bonded to an upper surface 110U of the organic EL element 110. Further, the barrier member 130 is bonded to an upper surface 120U of the sealing material 120 on the side opposite to the bonding surface 120D. The present embodiment will be described by showing the barrier member 130 that includes a barrier layer 131 and a substrate film layer 132 disposed in the order of proximity to the sealing material 120.

In the light-emitting device 100 according to the first embodiment having such a structure, the organic EL element 110 including the light emitting layers 114 is sealed by the sealing material 120 and the barrier member 130. This configuration can achieve excellent sealing and enhance the properties of the light-emitting device 100, such as lifetime.

Further, the sealing material 120 before sealing had the bonding surface 120D of the specific arithmetic average roughness Ra. Thus, when the sealing is performed by boding the bonding surface 120D to the upper surface 110U of the organic EL element 110, the occurrence of air bubbles and dark spots can be suppressed. As a result, the light-emitting device 100 can achieve excellent light emission.

The light-emitting device 100 having such a configuration may be produced by a production method including a step of bonding the bonding surface 120D of the sealing material 120 to the organic EL element 110 and a step of bonding the barrier member 130 to the upper surface 120U of the sealing material 120 on the side opposite to the bonding surface 120D. For example, the light-emitting device 100 may be produced by stacking the organic EL element 110, the sealing material 120, and the barrier member 130 in this order with the bonding surface 120D of the sealing material 120 facing the side of the organic EL element 110, and press-bonding the organic EL element 110 and the barrier member 130 via the sealing material 120 at the specific sealing temperature.

### [6. 2. Second embodiment]

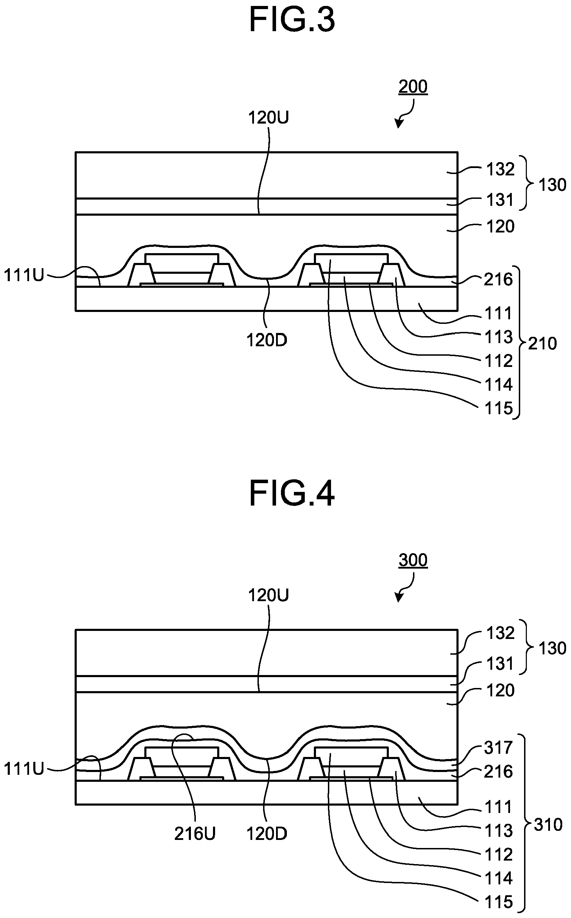

FIG. 3 is a vertical cross-sectional view schematically illustrating a light-emitting device 200 according to a second embodiment of the present invention. Among components of the light-emitting device 200 according to the second embodiment, the same components as those in the light-emitting device 100 according to the first embodiment are denoted by the same reference numerals as those in the light-emitting device 100 according to the first embodiment.

As shown in Fig. 3, the light-emitting device 200 according to the second embodiment has the same configuration as the light-emitting device 100 according to the first embodiment except that an organic EL element 210 includes a temporary sealing layer 216 that is formed so as to cover the entirety of the substrate 111, the first electrodes 112, the edge cover layers 113, the light emitting layers 114, and the second electrodes 115.

Examples of the material of the temporary sealing layer 216 may include a material containing silicon, such as SiN and SiO. The thickness of the temporary sealing layer 216 may be set to about 0.2 µm to 1 µm.

The temporary sealing layer 216 may be formed, for example, by a film forming method such as vapor deposition, in the same reduced pressure environment as used for the light emitting layers 114 and the second electrodes 115. Thus, deterioration of the light emitting layers 114 can be effectively suppressed by continuously providing the light emitting layers 114, the second electrodes 115, and the temporary sealing layer 216 in the reduced pressure environment. Further, after taking these assemblies out of the reduced pressure environment, the organic EL element 210 may be sealed by the sealing material 120 and the barrier member 130, thereby strong sealing capable of withstanding the use environment of the light-emitting device 200 can be achieved. In this manner, it is possible to obtain the light-emitting device 200 in which the organic EL element 210 is less susceptible to deterioration during the production and such a state of the organic EL element 210 is maintained for a long period of time under the use environment.

Further, the light-emitting device 200 according to the present embodiment can exhibit the same advantageous effects as the light-emitting device 100 according to the first embodiment.

### [6. 3. Third embodiment]

FIG. 4 is a vertical cross-sectional view schematically illustrating a light-emitting device 300 according to a third embodiment of the present invention. Among components of the light-emitting device 300 according to the third embodiment, the same components as those in the light-emitting devices 100 and 200 according to the first embodiment and the second embodiment are denoted by the same reference numerals as those in the light-emitting devices 100 and 200 according to the first embodiment and the second embodiment.

As shown in Fig. 4, the light-emitting device 300 according to the third embodiment has the same configuration as the light-emitting device 100 according to the first embodiment except that an organic EL element 310 includes the temporary sealing layer 216 and an adsorbent layer 317, which are formed so as to cover the entirety of the substrate 111, the first electrodes 112, the edge cover layers 113, the light emitting layers 114, and the second electrodes 115.

The adsorbent layer 317 is a layer disposed on an upper surface 216U of the temporary sealing layer 216. Examples of the material of the adsorbent layer 317 may include an organic aluminum complex. The thickness of the adsorbent layer 317 may be set to about 0.1 µm to 1 µm.

By having the adsorbent layer 317, strength of the sealing can be further enhanced. For example, the absorbent layer 317 can absorb the outgas that may be released from the sealing material 120, to thereby achieve still higher level of prevention of deterioration of the layers such as the light emitting layers 114.

Further, the light-emitting device 300 according to the present embodiment can exhibit the same advantageous effects as the light-emitting devices 100 and 200 according to the first embodiment and the second embodiment.

### [EXAMPLES]

The present invention will be described in detail by way of Examples below. However, the present invention is not limited to the following Examples and may be freely modified and implemented without departing from the scope of claims of the present invention and the scope of their equivalents.

Unless otherwise specified, "%" and "part" referring to an amount in the following description are on the basis of weight. Further, unless otherwise specified, the operations described below were performed in an atmospheric air of normal temperature and normal pressure.

### [Production Example 1: production of sealing film 1]

A block copolymer having a tri-block structure in which polymer blocks [A] were bonded to both ends of a polymer block [B] was produced using styrene as an aromatic vinyl compound and isoprene as a linear conjugated diene compound by the following procedures.

Into a reaction vessel equipped with a stirring device, inner atmosphere of which had been sufficiently replaced with nitrogen, 256 parts of dehydrated cyclohexane, 25.0 parts of dehydrated styrene, and 0.615 parts of n-dibutyl ether were placed. Then, 1.35 parts of n-butyl lithium (15% solution in cyclohexane) was added to the mixture while stirring at 60°C to initiate polymerization. Further, the reaction was performed for 60 minutes while stirring at 60°C. The polymerization conversion ratio at this point was 99.5% (the polymerization conversion ratio was measured by gas chromatography, the same applies in the following).

Subsequently, 50.0 parts of dehydrated isoprene was added and the mixture was continuously stirred for 30 minutes at the same temperature. The polymerization conversion ratio at this point was 99%. Subsequently, 25.0 parts of dehydrated styrene was further added and the mixture was stirred for 60 minutes at the same temperature. The polymerization conversion ratio at this point was almost 100%. Subsequently, 0.5 parts of isopropyl alcohol was added to the reaction liquid to terminate the reaction, thereby obtaining a solution (i) containing a block copolymer. The weight-average molecular weight (Mw) of the block copolymer in the obtained solution (i) was 44,900, and the molecular weight distribution (Mw/Mn) was 1.03.

Subsequently, the solution (i) was transferred into a pressure-resistant reaction vessel equipped with a stirring device, and 4.0 parts of a silica-alumina supported type nickel catalyst (E22U, nickel support amount of 60%; manufactured by JGC C & C) as a hydrogenation catalyst and 350 parts of dehydrated cyclohexane were added and mixed. The atmosphere in the reaction vessel was replaced with hydrogen gas, and hydrogen was further supplied to the solution while stirring to perform a hydrogenation reaction at a temperature of 170°C and under a pressure of 4.5 MPa for 6 hours. The block copolymer was thereby hydrogenated to obtain a solution (iii) containing a hydrogenated product of the block copolymer (ii). The weight-average molecular weight (Mw) of the hydrogenated product of the block copolymer (ii) in the solution (iii) was 45,100, and the molecular weight distribution (Mw/Mn) was 1.04.

After the completion of the hydrogenation reaction, the solution (iii) was filtered to remove the hydrogenation catalyst. Then, 1.0 part of a xylene solution, in which 0.1 parts of 6-[3-(3-t-butyl-4-hydroxy-5-methylphenyl)propoxy]-2,4,8,10-tetrakis-t-butyldibenzo[d,f][1.3.2]dioxaphosphepin ("Sumilizer (registered trademark) GP" manufactured by Sumitomo Chemical Co. Ltd., hereinafter referred to as an "antioxidant A") as a phosphorus-based antioxidant had been dissolved, was added and dissolved in the filtered solution (iii) to obtain a solution (iv).

Subsequently, the solution (iv) was filtered through a filter ("Zeta-plus (registered trademark) filter 30H" manufactured by CUNO, pore size of 0.5 µ to 1 µm), and further filtered through another metal fiber filter (pore size of 0.4 µm, manufactured by Nichidai Co., Ltd.) sequentially to remove a minute solid content. Cyclohexane and xylene, which were used as a solvent, and other volatile components were removed from the filtered solution (iv) at a temperature of 260°C and under a pressure of 0.001 MPa or less using a cylindrical concentration dryer ("KONTRO", manufactured by Hitachi, Ltd.). Then, a solid content of the solution (iv) in a molten state was extruded into a strand shape from a die directly connected to the concentration dryer described above. The extruded product was cooled and cut by a pelletizer to obtain pellets (v) of the sealing resin containing the hydrogenated product of the block copolymer and the antioxidant A. The storage elastic modulus of the sealing resin was measured by a dynamic viscoelasticity measuring device ("Rheosol-G30000" manufactured by UBM) at a frequency of 10 Hz and a temperature elevation rate of 5°C/min, and it was 50 MPa at 90°C. Further, the tensile elastic modulus of the sealing resin was measured by a Tensilon universal tester (RTC-1125A manufactured by ORIENTEC Ltd.) according to JIS K 7162 under the conditions of a distance between gauge points of 25 mm and a tensile rate of 50 mm/min, and it was 1,443 MPa at 23°C.

The pellets (v) described above were subjected to single-screw extrusion molding at a barrel temperature of 200°C to obtain a resin film having a thickness of 50 µm. One surface of the obtained resin film was pressed by an emboss plate having a rough surface under the pressure of 5 MPa while heating at 120°C to transfer the shape of the rough surface of the emboss plate on the pressed surface of the resin film described above, thereby obtaining a sealing film 1 as a sealing material. The arithmetic average roughness Ra of the emboss pattern-transferred surface of the obtained sealing film 1 was measured by an atomic force microscope ("SPA300" manufactured by SII NanoTechnology Inc.), and it was 20 nm.

### [Production Example 2: production of sealing film 2]

A sealing film 2 was produced in the same manner as in Production Example 1 except that the emboss plate was changed to another emboss plate. The sealing film 2 had the arithmetic average roughness Ra on the emboss pattern-transferred surface of 500 nm, the storage elastic modulus at 90°C of 50 MPa, and the tensile elastic modulus at 23°C of 1,443 MPa.

### [Production Example 3: production of sealing film 3]

In a dry room where a dew-point temperature was -60°C, 90 parts by weight of the pellets (v) of the sealing resin produced in Production Example 1 and 10 parts by weight of barium oxide were melt-kneaded in a twin-screw extruder and then extruded therefrom to obtain a strand. The strand is molded by a pelletizer to produce pellets (vi) of a sealing resin. The storage elastic modulus of the sealing resin was measured by the dynamic viscoelasticity measuring device ("Rheosol-G30000" manufactured by UBM) at a frequency of 10 Hz and a temperature elevation rate of 5°C/min, and it was 30 MPa at 90°C. Further, the tensile elastic modulus of the sealing resin was measured by a Tensilon universal tester (RTC-1125A manufactured by ORIENTEC Ltd.) according to JIS K 7162 under the conditions of a distance between gauge points of 25 mm and a tensile rate of 50 mm/min, and it was 1,411 MPa at 23°C.

The pellets (vi) described above were subjected to single-screw extrusion molding at a barrel temperature of 200°C to obtain a resin film having a thickness of 50 µm. One surface of the obtained resin film was pressed by the emboss plate having a rough surface under the pressure of 5 MPa while heating at 120°C to produce a sealing film 3 having the arithmetic average roughness Ra on the emboss pattern-transferred surface of 900 nm.

### [Production Example 4: production of sealing film 4]

Into a 1 liter flask equipped with a stirring device, a thermometer, and a condenser, 23.6 g of toluene diisocyanate ("CORONATE T-100" manufactured by Tosoh Corp.), 13.3 g of ethyl diglycol acetate, and 31.9 g of an organic solvent ("Swazole#1000" manufactured by Maruzen Petrochemical) were charged and the mixture was stirred at the room temperature under a nitrogen atmosphere. To the flask, a mixture containing 6.1 g of 1,4-butanediol and 13.3 g of ethyl diglycol acetate was added, and further 0.7 g of 1% dioctyltin dilaurate ("NEOSTANN U-810" manufactured by NITTOH CHEMICAL Co., Ltd.) solution in the organic solvent ("Swazole#1000" manufactured by Maruzen Petrochemical) was added. The temperature was raised to 80°C and the reaction was performed for 90 minutes. After cooling the reaction product to 60°C or lower, a mixture containing 129.1 g of hydrogenated polybutadiene ("GI-3000" manufactured by NIPPON SODA Co., Ltd., hydroxyl value of 30 mgKOH/g), 13.3 g of ethyl diglycol acetate, and 47.8 g of the organic solvent ("Swazole#1000" manufactured by Maruzen Petrochemical) was added, and further 1.4 g of 1% dioctyltin dilaurate ("NEOSTANN U-810" manufactured by NITTOH CHEMICAL Co., Ltd.) solution in the organic solvent ("Swazole#1000" manufactured by Maruzen Petrochemical) was added. The temperature was raised to 80°C and the reaction was performed for 80 minutes. After cooling the reaction product to 40°C, a mixture containing 6.1 g of 1,4-butanediol and 13.3 g of ethyl diglycol acetate was added. The temperature was raised to 80°C and the reaction was further performed for 90 minutes. After confirming disappearance of the absorption attributable to an isocyanate group (2,274 cm⁻¹) by infrared spectroscopic analysis, the reaction was terminated to obtain a reaction product 1. Subsequently, into a 1 liter flask equipped with a stirring device, a thermometer, and a condenser, 311.1 g of the reaction product 1, 7.4 g of ethyl diglycol acetate, 55.8 g of the organic solvent ("Swazole#1000" manufactured by Maruzen Petrochemical) were charged. While the flask was stirred at the room temperature under a nitrogen atmosphere, a mixture containing 12.3 g of toluene diisocyanate ("CORONATE T-100" manufactured by Tosoh Corp.) and 9.3 g of ethyl diglycol acetate was added. The temperature was raised to 80°C and the reaction was performed for 90 minutes. After cooling the reaction product to the room temperature, 55.9 g of an epoxy compound ("JER-1001" manufactured by Mitsubishi Chemical Corp., an epoxy compound having one or more hydroxyl groups and one or more glycidyl ether structures in the molecule) in terms of solid content, the epoxy compound being solved in ethyl diglycol acetate at 70%, and 17.5 g of ethyl diglycol acetate were added while stirring. The temperature was raised to 45°C and the reaction was performed for 1 hour. Subsequently, 0.78 g of isobutyl alcohol and 3.0 g of ethyl diglycol acetate were added, and after the reaction was performed for 30 minutes, 3.1 g of 1% dioctyltin dilaurate ("NEOSTANN U-810" manufactured by NITTOH CHEMICAL Co., Ltd.) solution in the organic solvent ("Swazole#1000" manufactured by Maruzen Petrochemical) was added. The temperature was raised to 110°C and the reaction was performed for 2 hours. After confirming disappearance of the absorption attributable to an isocyanate group (2,274 cm⁻¹) by infrared spectroscopic analysis, the reaction was terminated to obtain a polybutadiene resin having an epoxy group and a urethane structure (product 1).

As a thiol compound, tris(3-mercaptopropyl)isocyanurate was synthesized according to the method described in Japanese Patent Application Laid-Open No. Sho. 56-120671 A and used as it was. Specifically, triallylisocyanurate (manufactured by Nippon Kasei Chemical Co., Ltd) and thiolpropionic acid (manufactured by City Chemical LLC) were irradiated with ultraviolet rays in a mixed solvent of acetone and acetic acid to induce a reaction. After removing the solvent under a reduced pressure, residues of the reaction solution were boiled in concentrated hydrochloric acid and neutralized with anhydrous sodium carbonate. Subsequently, the neutralized solution was passed through an activated alumina column to remove the solvent, thereby obtaining tris(3-mercaptopropyl)isocyanurate.

After mixing 44.4 g of the product 1 in terms of solid content, 2.6 g of tris(3-mercaptopropyl)isocyanurate thus synthesized, and 4.6 g of hydrophobic silica ("R-805" manufactured by NIPPON AEROSIL Co., Ltd., average particle diameter of 0.012 µm) as an inorganic filler and kneading a mixture by using a three-roll mill, 2.0 g of the organic solvent ("Swazole#1000" manufactured by Maruzen Petrochemical) was added to the mixture to adjust a viscosity to about 35 pa·s. Finally, 2.2 g of 1,2-dimethylimidazole ("Nichigo imidazole 1,2-DMI" manufactured by Nippon Synthetic Chemical Industry Co., Ltd.) was added as a curing catalyst and the resulting mixture was stirred with a revolving-rotating mixer ("Awatori Rentaro AR-100" manufactured by THINKY) to produce a resin varnish. The resin varnish was cured at 80°C for 60 minutes. The storage elastic modulus of the cured resin thus obtained was measured by the dynamic viscoelasticity measuring device ("Rheosol-G30000" manufactured by UBM) at a frequency of 10 Hz and a temperature elevation rate of 5°C/min, and it was 40 MPa at 90°C. Further, the tensile elastic modulus of the sealing resin was measured by a Tensilon universal tester (RTC-1125A manufactured by ORIENTEC Ltd.) according to JIS K 7162 under the conditions of a distance between gauge points of 25 mm and a tensile rate of 50 mm/min, and it was 2,400 MPa at 23°C.

The obtained resin varnish was applied onto a polytetrafluoroethylene release film ("Aflex 50N" manufactured by ASAHI GLASS Co., Ltd.) using a bar coater and cured at 80°C for 60 min to obtain a resin film. One surface of the obtained resin film was pressed by the emboss plate having a rough surface under the pressure of 5 MPa while heating at 120°C to transfer the shape of the rough surface of the emboss plate on the pressed surface of the resin film described above, thereby obtaining a sealing film 4. The arithmetic average roughness Ra of the emboss pattern-transferred surface of the obtained sealing film 4 was measured by the atomic force microscope ("SPA300" manufactured by SII NanoTechnology Inc.), and it was 50 nm.

### [Production Example 5: production of sealing film 5]

A reaction vessel equipped with a stirring device was prepared and the internal atmosphere was sufficiently replaced with nitrogen. Into the reaction vessel, 550 parts of dehydrated cyclohexane, 25.0 parts of dehydrated styrene, and 0.59 parts of n-dibutyl ether were placed. Then, 1.14 parts of n-butyl lithium (15% solution in cyclohexane) was added to the mixture while stirring at 60°C to initiate polymerization. Subsequently, the reaction was performed for 60 minutes, while stirring at 60°C. Then, the polymerization conversion ratio of the obtained reaction mixture was measured to find that it was 99.5% at this point (the polymerization conversion ratio was measured by gas chromatography, the same applies in the following).

Subsequently, 50.0 parts of dehydrated isoprene was added to the reaction vessel and the mixture was continuously stirred for 30 minutes. The polymerization conversion ratio at this point was 99.5%.

Subsequently, 25.0 parts of dehydrated styrene was further added to the reaction vessel and the mixture was stirred for 60 min. The polymerization conversion ratio at this point was almost 100%. Then, 0.5 parts of isopropyl alcohol was added to the reaction vessel to terminate the reaction, thereby obtaining a solution (vii) containing a block copolymer. The obtained block copolymer had the weight-average molecular weight (Mw) of 47,000, the molecular weight distribution (Mw/Mn) of 1.03, and the ratio wA/wB between the weight fraction wA of the styrene polymer blocks and the weight fraction wB of the isoprene polymer blocks of 50/50.

Subsequently, the solution (vii) was transferred into a pressure-resistant reaction vessel equipped with a stirring device. Into the pressure-resistant reaction vessel, 3.0 parts of a diatomaceous earth supported type nickel catalyst ("T-8400RL" manufactured by Süd-Chemie) as a hydrogenation catalyst and 100 parts of dehydrated cyclohexane were added. The atmosphere in the reaction vessel was replaced with hydrogen gas, and hydrogen was further supplied to the solution while stirring to perform a hydrogenation reaction at a temperature of 190°C and under a pressure of 4.5 MPa for 6 hours. The block copolymer was thereby hydrogenated to obtain a solution (ix) containing a hydrogenated product of the block copolymer (viii). The weight-average molecular weight (Mw) of the hydrogenated product of the block copolymer (viii) in the solution (ix) was 48,000, and the molecular weight distribution (Mw/Mn) was 1.04.

After the completion of the hydrogenation reaction, the solution (ix) was filtered to remove the hydrogenation catalyst. Then, 1.0 part of a xylene solution, in which 0.1 parts of pentaerythrityl·tetrakis[3-(3,5-di-t-butyl-4-hydroxyphenyl) propionate] ("Songnox1010" manufactured by SONGWON) as a phenol-based antioxidant had been dissolved, was added and dissolved in the filtered solution (ix) to obtain a solution (x).

Subsequently, the solution (x) was filtered through the metal fiber filter (pore size of 0.4 µm, manufactured by Nichidai Co., Ltd.) to remove a minute solid content. Then, cyclohexane and xylene, which were used as a solvent, and other volatile components were removed from the filtered solution (x) at a temperature of 260°C and under a pressure of 0.001 MPa or less using the cylindrical concentration dryer ("KONTRO", manufactured by Hitachi, Ltd.) to obtain a molten polymer. The molten polymer was sequentially filtered with a polymer filter (manufactured by FUJI FILTER MFG. Co., Ltd.) equipped with a stainless steel sintered filter having a pore size of 5 µm, the polymer filter being connected to the aforementioned concentration dryer, at a temperature of 260°C. Subsequently, the molten polymer was extruded into a strand shape from a die. The extruded product was cooled and then cut by a pelletizer to produce 96 parts of pellets of a hydrogenated product of the block copolymer (xi). The obtained hydrogenated product of the block copolymer (xi) had the weight-average molecular weight (Mw) of 48,000 and the molecular weight distribution (Mw/Mn) of 1.04. The hydrogenation ratio was almost 100%.

To 100 parts of the obtained pellets of the hydrogenated product of the block copolymer (xi), 2.0 parts of vinyl trimethoxysilane and 0.2 parts of 2,5-dimethyl-2,5-di(t-butylperoxy)hexane ("PERHEXA (registered trademark) 25B" manufactured by NOF Corp.) were added to obtain a mixture. The mixture was kneaded by a twin-screw extruder ("TEM37B" manufactured by TOSHIBA MACHINE Co., Ltd.) at a resin temperature of 200°C and for a retention time of 60 sec to 70 sec, and extruded into a strand shape from the twin-screw extruder. The extruded product was cooled by air and then cut by a pelletizer to obtain 97 parts of pellets of a hydrogenated product of the modified block copolymer (xii) having an alkoxysilyl group.

After dissolving 10 parts of the obtained pellets of the hydrogenated product of the modified block copolymer (xii) into 100 parts of cyclohexane, the resulting solution was poured into 400 parts of dehydrated methanol to solidify the hydrogenated product of the modified block copolymer (xii). After separating the solidified hydrogenated product of the modified block copolymer (xii) by filtration, the filtered products were vacuum-dried at 25°C to isolate 9.5 parts of crumbs of the hydrogenated product of the modified block copolymer (xii). The FT-IR spectrum and ¹H-NMR spectrum of the isolated crumbs were observed. In the FT-IR spectrum, a new absorption band attributable to an Si-OCH₃ group was observed at 1,090 cm⁻¹, and new absorption bands attributable to an Si-CH₂ group were observed at 825 cm⁻¹ and 739 cm⁻¹. Locations of these absorption bands were different from 1,075 cm⁻¹, 808 cm⁻¹, and 766 cm⁻¹ corresponding to the locations of the absorption bands of vinyltrimethoxysilane. Further, in the ¹H-NMR spectrum (in deuterated chloroform), an absorption band based on the proton of the methoxy group was observed at 3.6 ppm. From the peak area ratio observed in these spectrums, it was confirmed that 1.7 parts of vinyltrimethoxysilane was bonded to 100 parts of the hydrogenated product of the block copolymer (xi).

To 100 parts by weight of the pellets of the hydrogenated product of the modified block copolymer (xii), 0.5 parts of 2-hydroxy-4-n-octoxybenzophenone as an ultraviolet ray absorber was added to prepare a mixture. The mixture was extruded into a strand shape at a resin temperature of 190°C from a twin-screw extruder ("TEM37BS" manufactured by TOSHIBA MACHINE Co., Ltd.) equipped with a side feeder from which a liquid object can be supplied. During the extrusion, the mixture in the twin-screw extruder was continuously supplied, via the aforementioned side feeder, with polyisobutene ("Nisseki Polybutene LV-100" manufactured by JX Nippon Oil & Energy Corp., the number-average molecular weight of 500) as a plasticizer in such a manner that the ratio of the polyisobutene became 40 parts by weight relative to 100 parts by weight of the hydrogenated product of the modified block copolymer (xii). After cooled by air, the extruded mixture was cut by a pelletizer to obtain 102 parts of resin pellets (xiii) containing the hydrogenated product of the modified block copolymer (xii) and polyisobutene. The storage elastic modulus of the resin was measured by the dynamic viscoelasticity measuring device ("Rheosol-G30000" manufactured by UBM) at a frequency of 10 Hz and a temperature elevation rate of 5°C/min, and it was 0.8 MPa at 90°C. Further, the tensile elastic modulus of the sealing resin was measured by a Tensilon universal tester (RTC-1125A manufactured by ORIENTEC Ltd.) according to JIS K 7162 under the conditions of a distance between gauge points of 25 mm and a tensile rate of 50 mm/min, and it was 939 MPa at 23°C.

The pellets (xiii) were subjected to single-screw extrusion molding at a barrel temperature of 200°C to obtain a resin film having a thickness of 50 µm. One surface of the obtained resin film was pressed by the emboss plate having a rough surface under the pressure of 5 MPa while heating at 120°C to transfer the shape of the rough surface of the emboss plate on the pressed surface of the resin film described above, thereby obtaining a sealing film 5. The arithmetic average roughness Ra of the emboss pattern-transferred surface of the obtained sealing film 5 was measured by an atomic force microscope ("SPA300" manufactured by SII NanoTechnology Inc.), and it was 100 nm.

### [Production Example 6: production of sealing film 6]

A sealing film 6 was produced in the same manner as in Production Example 1 except that a norbornene-based resin film ("ZF16-188" manufactured by ZEON Corp.) having a thickness of 188 µm was used as an emboss die in place of the emboss plate. The sealing film 6 had the arithmetic average roughness Ra on the emboss pattern-transferred surface of 2 nm.

### [Production Example 7: production of sealing film 7]

A sealing film 7 was produced in the same manner as in Production Example 1 except that the emboss plate was changed to another emboss plate. The sealing film 7 had the arithmetic average roughness Ra on the emboss pattern-transferred surface of 1500 nm.

### [Production Example 8: production of sealing film 8]

Pellets of a sealing resin (xiv) were obtained in the same manner as in Production Example 3 except that zeolite particles having an average particle diameter of 100 nm were used in place of barium oxide. The storage elastic modulus of the sealing resin was measured by the dynamic viscoelasticity measuring device ("Rheosol-G30000" manufactured by UBM) at a frequency of 10 Hz and a temperature elevation rate of 5°C/min, and it was 20 MPa at 90°C. Further, the tensile elastic modulus of the sealing resin was measured by a Tensilon universal tester (RTC-1125A manufactured by ORIENTEC Ltd.) according to JIS K 7162 under the conditions of a distance between gauge points of 25 mm and a tensile rate of 50 mm/min, and it was 1,325 MPa at 23°C.

The pellets (xiv) described above were subjected to single-screw extrusion molding at a barrel temperature of 200°C to obtain a resin film having a thickness of 50 µm. One surface of the obtained resin film was pressed by the emboss plate having a rough surface under the pressure of 5 MPa while heating at 120°C to produce a sealing film 8 having the arithmetic average roughness Ra on the emboss pattern-transferred surface of 300 nm.

### [Production Example 9: production of barrier member 1]

As the substrate film, a norbornene-based resin film ("ZF16-100" manufactured by ZEON Corp.) having a thickness of 100 µm was prepared. A silicon oxide film having a thickness of about 1000 nm was formed on this substrate film as a barrier layer by the plasma CVD method to obtain a barrier member 1.

### [Production Example 10: preparation of barrier member 2]

A stainless foil having a thickness of 100 µm was prepared and used as a barrier member 2.

### [Production Example 11: preparation of barrier member 3]

A glass film having a thickness of 100 µm was prepared and used as a barrier member 3.

### [Production Example 12: production of light-emitting element 1]

As the substrate, a 50mm-square glass film having a thickness of 0.1 mm was prepared.

An ITO layer having a thickness of 150 nm was formed on this glass film by vapor deposition (under a reduced pressure of 10⁻⁴ Pa) as first electrodes.

N,N'-diphenyl-N,N'-m-tolyl-4,4'-diamino-1,1'-biphenyl was deposited on the first electrodes by vapor deposition in a vacuum atmosphere of 5 × 10⁻⁴ Pa to form hole transport layers.

Alq3 (tris(8-hydroxyquinolinato)aluminum) was deposited on the hole transport layers by vapor deposition in a vacuum atmosphere of 5 × 10⁻⁴ Pa to form light-emitting layers.

LiF was deposited on the light-emitting layers by vapor deposition in a vacuum atmosphere of 5 × 10⁻⁴ Pa to form electron transport layers.

Al was deposited on the electron transport layers by vapor deposition in a vacuum atmosphere of 5 × 10⁻⁴ Pa to form second electrodes. In this manner, a light-emitting element 1 of a bottom emission type was obtained.

### [Production Example 13: production of light-emitting element 2]

As the substrate, a 50mm-square glass film having a thickness of 0.1 mm was prepared. Aluminum was deposited on the glass film to a thickness of 100 nm by vapor deposition to form reflection layers. SiO₂ was deposited on the reflection layers to a thickness of 20 nm by vapor deposition to form insulation layers. On the insulation layers, the first electrodes formed of ITO, the hole transport layers, the light-emitting layers, and the electron transport layers were formed in this order in the same manner as in Production Example 11. Further, on the electron transport layers, silver was deposited to a thickness of 10 nm by vapor deposition and then ITO was deposited to a thickness of 100 nm by vapor deposition to form light-transmitting second electrodes. In this manner, a light-emitting element 2 of a top emission type was obtained.

### [Example 1]

The light-emitting element 1, the sealing film 1 as the sealing material, and the barrier member 1 were stacked in this order, and the sealing was performed by thermocompression to obtain the organic EL element 1. In this process, the sealing film 1 was placed such that the bonding surface, on which the emboss pattern had been transferred, faced the side of the light-emitting element 1. Further, the thermocompression described above was performed using a vacuum laminator (manufactured by JOYO ENGINEERING Co., Ltd.) under the conditions of a heating temperature of 110°C, an applied pressure of 0.8 kN, a vacuum degree of 1.3 Pa, and a retention time of 5 minutes.

Inspecting the obtained organic EL element 1, it was found that the bonding was favorably completed without leaving air bubbles during the sealing process. Further, electricity was applied to the organic EL element 1, and it was confirmed that the element can emit light without any dark spots nor any defects. Subsequently, the organic EL element 1 was subjected to a durability test, in which the organic EL element 1 was allowed to stand at 85°C and 0%RH for 500 hours in a non-lighting state. After that, the organic EL element 1 was returned to the room temperature and electricity was applied again to turn on the organic EL element 1. As a result, it was confirmed that the organic EL element 1 can emit light without any dark spots nor any defects.

### [Example 2]

An organic EL element 2 was obtained in the same manner as in Example 1 except that the sealing film 2 was used in place of the sealing film 1 and the barrier member 2 was used in place of the barrier member 1.

Inspecting the obtained organic EL element 2, it was found that the bonding was favorably completed without leaving air bubbles during the bonding process. Further, electricity was applied to the organic EL element 2, and it was confirmed that the element can emit light without any dark spots nor any defects. Subsequently, the organic EL element 2 was subjected to a durability test, in which the organic EL element 2 was allowed to stand at 85°C for 500 hours in a non-lighting state. After that, the organic EL element 2 was returned to the room temperature and electricity was applied again to turn on the organic EL element 2. As a result, it was confirmed that the organic EL element 2 can emit light without any dark spots nor any defects.

### [Example 3]

An organic EL element 3 was obtained in the same manner as in Example 1 except that the light-emitting element 2 was used in place of the light-emitting element 1, the sealing film 3 was used in place of the sealing film 1, and the barrier member 3 was used in place of the barrier member 1.

Inspecting the obtained organic EL element 3, it was found that the bonding was favorably completed without leaving air bubbles during the bonding process. Further, electricity was applied to the organic EL element 3, and it was confirmed that the element can emit light without any dark spots nor any defects. Subsequently, the organic EL element 3 was subjected to a durability test, in which the organic EL element 3 was allowed to stand at 85°C for 500 hours in a non-lighting state. After that, the organic EL element 3 was returned to the room temperature and electricity was applied again to turn on the organic EL element 3. As a result, it was confirmed that the organic EL element 3 can emit light without any dark spots nor any defects.

### [Example 4]

An organic EL element 4 was obtained in the same manner as in Example 1 except that the light-emitting element 2 was used in place of the light-emitting element 1, and the sealing film 4 was used in place of the sealing film 1.

Inspecting the obtained organic EL element 4, it was found that the bonding was favorably completed without leaving air bubbles during the bonding process. Further, electricity was applied to the organic EL element 4, and it was confirmed that the element can emit light without any dark spots nor any defects. Subsequently, the organic EL element 4 was subjected to a durability test, in which the organic EL element 4 was allowed to stand at 85°C for 500 hours in a non-lighting state. After that, the organic EL element 4 was returned to the room temperature and electricity was applied again to turn on the organic EL element 4. As a result, it was confirmed that the organic EL element 4 can emit light without any dark spots nor any defects.

### [Example 5]

An organic EL element 5 was obtained in the same manner as in Example 1 except that the light-emitting element 2 was used in place of the light-emitting element 1, the sealing film 5 was used in place of the sealing film 1, and the barrier member 3 was used in place of the barrier member 1.

Inspecting the obtained organic EL element 5, it was found that the bonding was favorably completed without leaving air bubbles during the bonding process. Further, electricity was applied to the organic EL element 5, and it was confirmed that the element can emit light without any dark spots nor any defects. Subsequently, the organic EL element 5 was subjected to a durability test, in which the organic EL element 5 was allowed to stand at 85°C for 500 hours in a non-lighting state. After that, the organic EL element 5 was returned to the room temperature and electricity was applied again to turn on the organic EL element 5. As a result, although there were no dark spots, the sealing properties of the sealing part were deteriorated and a dark area (a non-light emitting area) was generated on the edge.

### [Example 6]

An organic EL element 6 was obtained in the same manner as in Example 1 except that the light-emitting element 2 was used in place of the light-emitting element 1, and the sealing film 8 was used in place of the sealing film 1.

Inspecting the obtained organic EL element 6, it was found that the bonding was favorably completed without leaving air bubbles during the bonding process. Further, electricity was applied to the organic EL element 6, and it was confirmed that the element can emit light without any dark spots nor any defects. Subsequently, the organic EL element 6 was subjected to a durability test, in which the organic EL element 6 was allowed to stand at 85°C for 500 hours in a non-lighting state. After that, the organic EL element 6 was returned to the room temperature and electricity was applied again to turn on the organic EL element 6. As a result, it was confirmed that the organic EL element 6 can emit light without any dark spots nor any defects.

### [Comparative Example 1]

An organic EL element 7 was obtained in the same manner as in Example 1 except that the light-emitting element 2 was used in place of the light-emitting element 1, and the sealing film 6 was used in place of the sealing film 1.

Inspecting the obtained organic EL element 7, it was found that air bubbles were left during the bonding process. Further, electricity was applied to the organic EL element 1. It was found that, although there were no dark spots, the brightness on the light emitting surface was uneven due to the remaining air bubbles. Subsequently, the organic EL element 6 was subjected to a durability test, in which the organic EL element 7 was allowed to stand at 85°C for 500 hours in a non-lighting state. After that, the organic EL element 7 was returned to the room temperature and electricity was applied again to turn on the organic EL element 7. As a result, the dark spots were generated in the areas where the air bubbles were left and the brightness on the light emitting surface was uneven.

### [Comparative Example 2]

An organic EL element 8 was obtained in the same manner as in Example 1 except that the sealing film 7 was used in place of the sealing film 1.

Inspecting the obtained organic EL element 8, it was found that the bonding was favorably completed without leaving air bubbles during the bonding process. However, when electricity was applied to the organic EL element 8, small dark spots were generated and the brightness on the light emitting surface was uneven. Subsequently, the organic EL element 8 was subjected to a durability test, in which the organic EL element 8 was allowed to stand at 85°C for 500 hours in a non-lighting state. After that, the organic EL element 8 was returned to the room temperature and electricity was applied again to turn on the organic EL element 8. As a result, it was found that the dark spots generated after the sealing process were remained and the brightness on the light emitting surface was uneven.

### [Evaluation results]

Results of Examples and Comparative Examples described above are shown in the table below. In the following table, "Ra" represents the arithmetic average roughness Ra of the emboss pattern-transferred surface of the sealing film.

**[Table 1. Results of Examples and Comparative Examples]**

| | Ra (nm) | Dark spots | Air bubbles |
|---|---|---|---|
| Ex. 1 | 20 | Good | Good |
| Ex. 2 | 500 | Good | Good |
| Ex. 3 | 900 | Good | Good |
| Ex. 4 | 50 | Good | Good |
| Ex. 5 | 100 | Good | Good |
| Ex. 6 | 300 | Good | Good |
| Comp. Ex. 1 | 2 | Good | Poor |
| Comp. Ex. 2 | 1500 | Poor | Good |

### [Discussion]

As apparent from Examples and Comparative Examples described above, it was confirmed that the sealing material of the present invention can seal the light-emitting element while suppressing the occurrence of the air bubbles and the dark spots.

### [Reference Sign List]

- 100: light-emitting device
- 110: organic EL element
- 111: substrate
- 112: first electrode
- 113: edge cover layer
- 114: light-emitting layer
- 115: second electrode
- 120: sealing material
- 120D: bonding surface
- 130: barrier member
- 131: barrier layer
- 132: substrate film layer
- 200: light-emitting device
- 210: organic EL element
- 216: temporary sealing layer
- 300: light-emitting device
- 310: organic EL element
- 317: adsorbent layer

## Claims

1. A sealing material for sealing a light-emitting element, wherein:
the sealing material has a bonding surface capable of being in contact with the light-emitting element; and
the bonding surface has an arithmetic average roughness of 10 nm or more and 1,000 nm or less.

2. The sealing material according to claim 1, wherein the sealing material has a storage elastic modulus at 90°C of 10 MPa or more.

3. The sealing material according to claim 1 or 2, wherein the sealing material has a tensile elastic modulus at 23°C of 1,500 MPa or less.

4. The sealing material according to any one of claims 1 to 3, wherein the sealing material is formed of a thermoplastic resin.

5. The sealing material according to claim 4, wherein the thermoplastic resin contains a hydrogenated product of an aromatic vinyl compound-conjugated diene block copolymer.

6. The sealing material according to any one of claims 1 to 5, wherein the sealing material contains a metal compound.

7. A method for producing the sealing material according to any one of claims 1 to 6, comprising the steps of:
molding a resin for forming the sealing material to obtain a resin film; and
processing a surface of the resin film to form a bonding surface having an arithmetic average roughness of 10 nm or more and 1,000 nm or less.

8. A method for producing a light-emitting device, comprising the steps of:
bonding a bonding surface of the sealing material according to any one of claims 1 to 6 to a light-emitting element; and
bonding a barrier member to a surface of the sealing material on a side opposite to the bonding surface.
